(19) Europäisches Patentamt

European Patent Office

Office européen des brevets

(11) **EP 0 942 434 B1**

(12) **EUROPÄISCHE PATENTSCHRIFT**

(45) Veröffentlichungstag und Bekanntmachung des Hinweises auf die Patenterteilung:
**01.09.2004  Patentblatt 2004/36**

(51) Int Cl.⁷: **G11C 19/00**, G06F 9/46

(21) Anmeldenummer: **99250069.4**

(22) Anmeldetag: **08.03.1999**

(54) **Schieberegister und Mikroprozessoranordnung**

Shift register and microprocessor arrangement

Registre à décalage et dispositif à microprocesseurs

(84) Benannte Vertragsstaaten:
**DE FR GB**

(30) Priorität: **09.03.1998  DE 19811201**

(43) Veröffentlichungstag der Anmeldung:
**15.09.1999  Patentblatt 1999/37**

(73) Patentinhaber: **GMD - FORSCHUNGSZENTRUM INFORMATIONSTECHNIK GMBH
D-53757 Sankt Augustin (DE)**

(72) Erfinder: **Kujawski, Frank
12043 Berlin (DE)**

(74) Vertreter: **Eisenführ, Speiser & Partner
Patentanwälte Rechtsanwälte
Spreepalais am Dom
Anna-Louisa-Karsch-Strasse 2
10178 Berlin (DE)**

(56) Entgegenhaltungen:
**EP-A- 0 518 420          EP-A- 0 644 478
US-A- 5 497 496**

**Beschreibung**

Die Erfindung betrifft ein Schieberegister gemäß dem Oberbegriff des Anspruchs 1.

Die Evolution der Entwicklung von innovativen Mikroprozessoren führt zu immer größer werdenden Anforderungen an die Hardware, in der diese Mikroprozessoren und die angeschlossenen Peripherieeinheiten eingebettet werden. Bustransfers werden im Pipelineverfahren getrennt als Adreßtransfer (Auftrag) und Datentransfer durchgeführt, um hohe Bustransferraten zu erreichen und unnötige Latenzzeiten zu vermeiden, denn in jedem Evolutionsschritt müssen wesentlich mehr Daten verarbeitet, und damit auch an die Prozessoren herangeführt werden, als in dem Schritt davor. Das führt dazu, daß Datentransfers nicht mehr unbedingt in der Reihenfolge, in der die Aufträge erteilt wurden, durchgeführt werden müssen, sondern auch ungeordnet geschehen können. Die Peripherieeinheit, die zuerst einen Datentransfer durchführen kann, bekommt den Datenbus, auch wenn der Auftrag dafür erst nach zeitlich früheren Aufträgen für andere Einheiten ausgegeben worden ist (Out Of Order Bustransfer).

Es sind zur Zeit nur wenige Mikroprosessortypen bekannt, die "pipelined split transaction transfers with out of order cycle completion" mit zusätzlichem Intervention-Transfer an ihrer Busschnittstelle durchführen, der Motorola MPC620, der bau-gleiche IBM PPC620 und dessen Wachfolgetyp IBM Power3. Es existieren nur wenige Schaltungen, in denen Mikroprozessoren dieser Bauarten eingesetzt werden. Dabei läßt sich erkennen, daß in diesen Schaltungen kein zentrales Interface zwischen den Prozessoren und den angeschlossenen Einheiten verwendet wird. Jede angeschlossene Einheit besitzt ihr eigenes Prozessorinterface, zentral gibt es nur wenige Spezialeinheiten, wie Adreß- und Datenbusarbitriereinheiten und spezielle Statusdekoder, wie es in den Handbüchern der Mikroprozessorhersteller vorgeschlagen worden ist. Die Komplexität des Businterfaces der oben genannten Mikroprozessortypen muß in jedem Einzelbusinterface berücksichtigt und nachgebildet werden, was für den Entwickler einer anzuschließenden Peripherieeinheit sehr viel Zeit und viel Aufwand für die Entwicklung dieser Einheit kostet. Darüberhinaus werden die Signalwege je nach Anzahl der anzuschließenden Einheiten entsprechend lang und kapazitiv belastet, was die Anfälligkeit für Störungen erheblich erhöhen kann. Bei Bustaktfrequenzen von 66 MHz kann dieses zu unlösbaren elektrischen Problemen führen.

Da die existierenden Schaltungen für jede an das Businterface der Mikroprozessoren angeschlossene Einheit ein separates Interface verwenden, wird natürlich auch in jedem Einzelinterface eine komplette Auftrags-Queue nachgebildet, in der alle Auftragsparameter gespeichert sein müssen, damit das Transferprotokoll eingehalten werden kann.

Vorangegangene Entwicklungen in der GMD haben gezeigt, daß es bei den heute üblichen hohen Bustransferraten und den damit verbundenen hohen Systemtaktraten aus elektrischen Gründen nicht ratsam ist, für jede Peripherieeinheit ein eigenes Interface zu implementieren. Das bringt Vorteile bei der elektrischen Sicherheit und beim Aufwand für die Entwickler der anzuschließenden Peripherieeinheiten wegen der Transparenz der Prozessoren.

Das bedeutet aber, daß man entsprechend den privaten Auftrags-Queues, die für jede Einheit separat vorhanden sein müssen, in diesem Zentral-Interface für jede Einheit eine spezielle Auftrags-Queue nachbilden muß, um eine Zuordnung der Aufträge zum auftragserteilenden Prozessor zu erreichen. In diesen Auftrags-Queues stehen außer dem Auftrag spezielle Signale, die die Peripherieeinheiten nicht unbedingt benötigen, wie etwa Prozessorkennung und Tags. Sie können daher entsprechend breit werden, für die Peripherieeinheiten werden diese Signale jedoch transparent, wodurch deren Auftragsqueue entsprechend abgemagert wird. Zusätzlich braucht man einen aufwendigen Datenbusverteiler, der die Zuordnung überwacht und eine Datenbusverteilung nach den Anforderungen der Peripherieeinheiten und den zugeordneten Prozessoren vornimmt. Um diesen Aufwand zu vermeiden, hat man bisher oft auf Out-Of-Order-Bustransfers verzichtet und eine strenge Einhaltung der Reihenfolge der Datentransfers bezüglich der Aufträge vorgenommen, denn in diesem Fall braucht man nur eine einzige Auftrags-Queue und einen sehr einfachen Datenbusverteiler.

Mikroprozessoren der neuesten Generation unterstützen in ihrem Businterface nicht nur Pipeline-Transfers, sie besitzen auch die Eigenschaft, diese Transfers zeitlich zu trennen als alleinigen Adreßtransfer und als alleinigen Datentransfer. Darüberhinaus können die Datentransfers auch in einer anderen Reihenfolge als die vorangegangenen Adreßtransfers geschehen. Es können somit vom Mikroprozessor Adressen bis zu einer bestimmten, maximalen Anzahl ausgegeben werden, ohne daß die dazugehörigen Daten transportiert worden sind. Die Daten werden dann je nach Zugriffszeit der vorher mittels Adreßtransfer angesprochenen Peripherieeinheit später transferiert. Da die Zugriffszeiten der Peripherieeinheiten variieren, kann es geschehen, daß vom Mikroprozessor verschiedene Einheiten nacheinander adressiert worden sind und die zuerst adressierte Einheit länger für die Bereitstellung oder Übernahmebereitschaft der Daten braucht, als die danach adressierten Einheiten. Somit besteht die Möglichkeit, daß Datenzyklusvertauschungen auftreten können. Man nennt diese Transferart "pipelined split transaction transfer with out of order cycle completion". Ein spezieller Transfer innerhalb dieses Mechanismus, der nur bei Mehrprozessorsystemen benutzt werden kann, ist der Intervention-Transfer. Diesem Transfer geht kein gesonderter Adreßtransfer voraus, es ist ein alleiniger Datentransfer zwischen zwei Prozessoren, um Cache-Daten auszutauschen. Bei diesem Transfer werden gleichzeitig im gemeinsamen Speicher die bisherigen Daten entsprechend modifiziert. Die Adresse, die eigentlich zu diesem Transfer gehört, ist schon in einem früheren Transferzyklus, der wegen eines Cache-Konflikts abgebrochen wurde, ausgegeben worden und muß sich von allen beteiligten Einheiten gemerkt werden.

Um diesen Transfermechanismus zu ermöglichen, ist es notwendig, zusätzliche Attribute wie Prozessorkennung, Zyklusart und Zyklusidentifikation zusammen mit den Adressen auszugeben. Die Gesamtheit von Adressen und deren Attributen wird im folgenden Auftrag genannt.

Es bestand die Aufgabe, ein zentrales Businterface für ein System mit mehreren Prozessoren und mehreren angeschlossenen Einheiten wie Speicher, Kommunikationseinheit und Peripheriekoppelungseinheit (PCI-Bridge) zu entwickeln. Es sollte mit möglichst wenigen Steuersignalen und einfachen Protokollen dafür gesorgt werden, daß eine einfache Implementierung der passiven Einheiten des Systems ermöglicht wird und eine vollständige Transparenz der Prozessoren aus der Sicht der passiven Einheiten erreicht wird. Dabei sollte der Hardware-Aufwand so gering wie möglich gehalten werden, damit dieses Interface nicht unbedingt in ASICs implementiert werden mußte, sondern auch noch in EPLDS Platz finden konnte. Die Taktfrequenz zwischen 50 und 66 MHz war vorgeschrieben. Es sollte nicht nur Pipeline-Transfers, sondern auch Out-Of-Order-Datentransfers mit der Möglichkeit für Intervention-Transfers zulassen.

Das Businterface müßte wegen der zeitlichen Trennung von schnell hintereinander folgenden Aufträgen und den später initiierten zugehörigen Datentransfers die Eigenschaft besitzen, alle Aufträge zwischenzuspeichern, um eine spätere Datenbusverteilung vorzunehmen, die abhängig von der Latenzzeit der Peripherieeinheiten, nicht aber nur abhängig von der Reihenfolge der Aufträge ist. Um solch eine Datenbusverteilung vorzunehmen, müßten dem Datenbusverteiler die Aufträge an die verschiedenen Einheiten parallel vorliegen, um dann je nach Bereitschaftsanzeige der Einheiten eine konfliktfreie Datenfreischaltung zu ermöglichen. Da die Auftragsattribute, die benötigt werden, ca. 20 Bit breit sind, müßten für drei Peripherieeinheiten drei 20 Bit breite Queues vor dem Datenbusverteiler geschaltet werden, was bei EPLD-Implementierungen bei einer Tiefe von je drei Aufträgen zu einer Belegung von 186 Makrozellen führte. Weiterhin müßten zusätzliche 20 Makrozellen benutzt werden, um für Intervention-Transfers Auftragszwischenspeicherungen vorzunehmen. Für weitere nötige Logik, wie den eigentlichen Datenbusverteiler, wäre bei den heutigen schnellen EPLDs kaum noch Platz, da für eine Taktfrequenz von 66 MHz mit einer Clock-to-Output-Zeit von 6 ns nur bis maximal 256 Makrozellen zur Verfügung stehen.

Es galt also, eine Möglichkeit zu schaffen, Makrozellen einzusparen. Würde man alle Auftragsattribute in nur einer Queue zwischenspeichern, so müßte man auf Out-Of-Order-Transfers verzichten und nur geordnete Transfers zulassen. Der Datenbusverteiler müßte mit der Freischaltung des Datenbus solange warten, bis die Einheit, deren Auftrag am Ausgang der Queue liegt, ihre Bereitschaft zum Transfer signalisiert. Gravierender ist, daß alle anderen Einheiten, deren Aufträge noch nicht sichtbar innerhalb der Queue liegen, auch wenn sie schneller wären, warten müßten, bis der gerade aktuelle Auftrag mit dem Datentransfer abgeschlossen ist. Die Einsparung der Makrozellen wäre jedoch beträchtlich, man bräuchte nur 62 Makrozellen für die Queue und weiterhin die 20 Makrozellen für den Intervention-Auftrag.

Der Verzicht auf Out-Of-Order-Transfers bringt jedoch beträchtliche Zeitverluste mit sich, die durch das Warten von schnellen Einheiten wegen eines nicht abgeschlossenen Transfers einer langsameren Einheit entstehen, und verhindert dadurch eine gute Auslastung das Datenbusses, die aber unbedingt nötig ist, um eine gute Gesamtleistung des Systems zu erreichen. Weiterhin gibt es im System eine Einheit die PCI-Bridge, die sowohl als Prozessor, als auch als passive Einheit fungiert. Bei nur geordneten Transfers könnte es zu katastrophalen Situationen (Dead-Locks) kommen, die dadurch entstehen, daß die PCI-Bridge gerade als Prozessor Aufträge ausgibt, während aber in der Auftragsqueue noch ein Auftrag an die PCI-Bridge als passive Einheit steckt. Die PCI-Bridge schaltet sich aber nur dann vom Master-Mode in den Slave-Mode um, wenn die Master-Aufträge abgeschlossen sind. Auf Out-Of-Order-Transfers durfte also nicht verzichtet werden.

Um trotzdem ein Minimum an Makrozellen zu verbrauchen, mußte also eine Queue geschaffen werden, die die Möglichkeit besitzt, Einträge innerhalb zu vertauschen. Um solche Vertauschungen vorzunehmen, mußte natürlich ein gewisser Teil der Daten, der sich innerhalb der Queue befindet, nach außen hin sichtbar gemacht werden. Außerdem müßte die Queue in der Lage sein, einen Auftrag, der sich gerade am Ausgang der Queue befindet, modifiziert wieder einzutragen, ohne daß man ihn erst von außen wieder an den Eingang legen müßte. Man hätte dann sogar die 20 Makrozellen für den Intervention-Auftrag gespart.

Die Aufgabe wird durch ein Schieberegister gemäß Anspruch 1 gelöst.

Die Erfindung schließt die technische Lehre ein, für die Auftrags-Warteschlange eines zentralen Bus-Interfaces ein Schieberegister vorzusehen, das Modifikationen der gespeicherten Daten und insbesondere der Reihenfolge der gespeicherten Daten ermöglicht, um die Auftragsreihenfolge bei Out-Of-Order-Bustransfers ändern zu können.

Das erfindungsgemäße Schieberegister weist hierzu neben dem Dateneingang zur Aufnahme der einzelnen Datenbits und dem Datenausgang zur Ausgabe der gespeicherten Datenbits einen Steuereingang auf, über den ein binäres Steuersignal aufgenommen wird, das bei einem vorgegebenen Wert den Inhalt des Schieberegisters modifiziert. Dies kann beispielsweise durch eine Änderung der Reihenfolge der gespeicherten Daten geschehen, indem beispielsweise die beiden ausgangsseitig gespeicherten Daten vertauscht werden. Es ist jedoch auch möglich, ein Datum (Datenwort bzw. Datenbit) in dem Schieberegister zu löschen, woraufhin alle nachfolgenden Daten um eine Stelle in Richtung Ausgang rutschen.

Die Speicherung der einzelnen Datenbits erfolgt jeweils durch ein binäres Speicherelement, das vorzugsweise aus einem Flip-Flop besteht, jedoch auch durch einen Doppelinverter (statisches Schieberegister) oder dynamische Inverter (dynamisches Schieberegister) gebildet werden kann, wobei die eigentliche Speicherung auf den Gate-Source-Kapazitäten der Inverter stattfindet. Die Erfindung ist jedoch hinsichtlich der zu verwendenden Speicherelemente nicht auf die vorstehend genannten Ausführungsbeispiele beschränkt, sondern läßt sich auch mit anderen Arten von Speicherelementen realisieren. Vorzugsweise arbeiten die Speicherelemente hierbei synchron, wobei ein Taktsignal dafür sorgt, daß sämtliche Speicherelemente gleichzeitig entweder bei einer steigenden oder einer fallenden Flanke des Taktsignals ihren Zustand ändern. Es ist jedoch auch möglich, asynchrone Speicherelemente zu verwenden.

Die Änderung der Reihenfolge der gespeicherten Datenbits wird erfindungsgemäß durch eine Steuerlogik bewirkt, die eingangsseitig zur Aufnahme des Steuersignals mit dem Steuereingang verbunden ist. Darüber hinaus ist die Steuerlogik eingangsseitig mit den Ausgängen der Speicherelemente verbunden, da eine Änderung der Reihenfolge der gespeicherten Datenbits die Kenntnis der aktuellen Reihenfolge der gespeicherten Datenbits voraussetzt. Die Steuerlogik verknüpft also die Ausgangssignale der Speicherelemente mit dem Steuersignal und steuert die Speicherelemente derart an, daß bei einem vorgegebenen Wert des Steuersignals die Reihenfolge der gespeicherten Datenbits verändert wird.

Dies kann beispielsweise derart geschehen, daß das zuerst über den Dateneingang des Schieberegisters aufgenommene und demzufolge ausgangsseitig gespeicherte Datenbit an den Eingang des Schieberegisters zurückgeführt wird, wobei die übrigen Datenbits um eine Stelle in Richtung Ausgang geschoben werden, was auch als Feedback bezeichnet wird.

In der bevorzugten Ausführungsform der Erfindung sind darüber hinaus weitere Steuereingänge vorgesehen, die mit entsprechenden binären Steuersignalen beaufschlagt werden können, um bei einem vorgegebenen Wert des jeweiligen Steuersignals eine Vertauschung der gespeicherten Datenbits zu bewirken. Ein Steuersignal bewirkt hierbei nach der Rückführung des ausgangsseitig gespeicherten Datenbits eine Invertierung des eingangsseitigen Datenbits. Ein anderes Steuersignal ermöglicht dagegen die Vertauschung der beiden ausgangsseitigen Datenbits.

In einer vorteilhaften Variante der Erfindung sind für das Einlesen eines Datenbits in das eingangsseitige Speicherelement und für die Ausgabe des ausgangsseitigen Datenbits getrennte Steuereingänge vorgesehen, was den Vorteil bietet, daß Eingabe und Ausgabe nicht notwendigerweise zusammen erfolgen müssen.

In diesem Fall kann der Füllungszustand des Schieberegisters in Abhängigkeit von der Ansteuerung variieren. Beträgt der Füllungszustand eines Schieberegisters mit einer Datentiefe von drei Bit beispielsweise zunächst drei Bit, was einem vollständig gefüllten Schieberegister entspricht, und werden anschließend zwei Bits ausgegeben, während lediglich ein Bit neu eingelesen wird, so ist der Füllungszustand anschließend nur noch zwei Bit. Zur Speicherung des aktuellen Füllungszustandes weist das Schieberegister deshalb vorzugsweise weitere Speicherelemente auf, die zur Kodierung des Füllungszustandes erforderlich sind.

So sind bei einem Schieberegister mit einer Datentiefe von drei Bit und einer Datenbreite von einem Bit insgesamt $2^3=8$ Kombinationen von Datenbits möglich, so daß bei einem konstanten Füllungszustand von drei Bit entsprechend drei binäre Speicherelemente ausreichen, um alle Zustände zu kodieren. Wegen der unterschiedlichen Füllungszustände wiederholen sich die Bitkombinationen jedoch in den vier möglichen Füllungszuständen, so daß insgesamt $2^{3+1}-1=15$ mögliche Kombinationen von Datenbits entstehen.

Es sind somit für die Kodierung der Datenbit-Kombinationen ganzzahlig aufgerundet $\log_2 15 = 4$ binäre Speicherelemente und für die Kodierung des Füllungszustandes ganzzahlig aufgerundet $\log_2 4 = 2$ binäre Speicherelemente erforderlich.

Da heutige moderne schnelle Schaltungen weniger mit diskreten Bauelementen zu realisieren sind, sondern als Teil einer integrierten Schaltung oder in programmierbaren Logikschaltungen realisiert werden, ist die Datenbreite des erfindungsgemäßen Schieberegisters nahezu beliebig wählbar. Grenzen dafür werden nur noch durch die vorhandene Siliziumfläche und den Integrationsgrad bei ASICs bzw. durch die Anzahl der vorhandenen logischen Makrozellen in EPLDs festgelegt.

Auch hinsichtlich der Datentiefe ist das erfindungsgemäße Schieberegister nicht auf die vorstehend beschriebene Variante mit einer Datentiefe von drei Bit beschränkt, sondern mit nahezu beliebigen Datentiefen realisierbar, wobei lediglich der mit zunehmender Datentiefe ansteigende Hardware-Aufwand zu berücksichtigen ist.

Zur Herstellung des vorstehend beschriebenen Schieberegisters ist zunächst die Zustandstabelle des Schieberegisters zu erstellen, wobei die gewünschten Werte von Datentiefe und Datenbreite sowie die Zahl und die Bedeutung der Steuersignale zu berücksichtigen sind. Anschließend muß daraus ein System von logischen Gleichungen für die Setz- bzw. Haltesignale der Speicherelemente erstellt werden, deren Werte zum einen vom Zustand des Schieberegisters, also von den Ausgängen der Speicherelemente, und zum anderen von den externen Steuersignalen abhängen. Dieses Gleichungssystem wird dann zweckmäßigerweise minimiert, um den Hardware-Aufwand zu verringern. Anschließend kann dann mit einer Hardware-Beschreibungssprache wie beispielsweise VE-RILOG der Schaltungsaufbau berechnet werden, wobei die schaltungstechnische Realisierung wahlweise unter Verwendung von programmierbaren Logikeinheiten (engl. EPLD - Electronically Programmable Logic Device) oder mit kundenspezifischen Schaltkreisen (engl. ASIC) erfolgen kann, deren Daten aus Software-Bibliotheken verfügbar sind.

In einer Variante der Erfindung wird das vorstehend beschriebene Schieberegister in einer Mehrprozessoranordnung eingesetzt, die mehrere Prozessoren und mehrere Peripherieeinheiten aufweist, wobei die Prozessoren und die Peripherieeinheiten über einen Adreßbus oder Adreßpfadschalter miteinander verbunden sind, um Aufträge (Adreßtransfers) von den Prozessoren zu den Peripherieeinheiten zu übertragen.

Die einzelnen Peripherieeinheiten weisen hierbei jeweils eine private Auftrags-Warteschlange auf, in der nur die eigenen Aufträge zwischengespeichert werden, solange die Peripherieeinheit noch mit der Abarbeitung früherer Aufträge beschäftigt ist.

Weiterhin ist eine zentrale Schnittstelle vorgesehen, um die Prozessoren für einen Datentransfer mit den Peripherieeinheiten zu verbinden. Dies ist erforderlich, da die Bustransfers im Pipeline-Verfahren getrennt als Adreßtransfer (Auftrag) und Datentransfer durchgeführt werden, um hohe Bustransferraten zu erreichen und unnötige Latenzzeiten zu vermeiden. Dies führt dazu, daß die Adreßtransfers nicht unbedingt in derselben Reihenfolge durchgeführt werden wie die Datentransfers, sondern auch ungeordnet erfolgen können, was auch als Out-Of-Order-Bustransfer bezeichnet wird. So wird der Datenbus derjenigen Peripherieeinheit zugeteilt, die zuerst für einen Datentransfer bereit ist, auch wenn frühere Aufträge für andere Peripherieeinheiten noch nicht abgearbeitet wurden. Die zentrale Schnittstelle hat deshalb die Aufgabe, den Peripherieeinheiten auf deren Anforderung hin den Datenbus zuzuteilen, was durch einen Datenbus-Verteiler erfolgt, dessen Kontrollsignale einerseits mit den Peripherieeinheiten und andererseits mit den Kontrollsignalen der Prozessoren verbunden sind.

Die Zuordnung muß hierbei in Abhängigkeit von dem jeweiligen Auftrag korrekt zu dem jeweils auftragserteilenden Prozessoren erfolgen. Zur Speicherung der von den Prozessoren abgegebenen Aufträge weist die Schnittstelle deshalb das vorstehend eingehend beschriebene Schieberegister auf. Vorteilhaft ist hierbei, daß sich die Reihenfolge der gespeicherten Aufträge durch eine entsprechende Ansteuerung der Steuereingänge (FB, INV, SW) ändern läßt, was erforderlich ist, um Out-Of-Order-Bustransfers durchführen zu können.

Andere vorteilhafte Weiterbildungen der Erfindung sind in den Unteransprüchen gekennzeichnet bzw. werden nachstehend zusammen mit der Beschreibung der bevorzugten Ausführung der Erfindung anhand der Figuren näher dargestellt. Es zeigen:

Figur 1      als bevorzugtes Ausführungsbeispiel der Erfindung ein steuerbares Schieberegister mit mehreren Flip-Flops zur Datenspeicherung in einer Darstellung als Blockschaltbild,

Figur 2      ein Signaldiagramm des in Figur 1 gezeigten Schieberegisters,

Figur 3      eine Logikschaltung des Schieberegisters aus Figur 1 zur Berechnung der möglichen Zustände aus den Flip-Flop-Zuständen,

Figur 4      eine weitere Logikschaltung des in Figur 1 dargestellten Schieberegisters zur Ansteuerung der Flip-Flops,

Figur 5      ein erfindungsgemäßes Schieberegister mit einer Datentiefe von drei Bit und einer Datenbreite von vier Bit,

Figur 6      eine Mikroprozessorschaltung, die unter Verwendung des erfindungsgemäßen Schieberegisters mit geringem Hardware-Aufwand Out-Of-Order-Bustrans-fers ermöglicht,

Figur 7      eine weitere derartige Mikroprozessorschaltung,

Figur 8      eine Baugruppe der Mikroprozessorschaltung aus Figur 7 sowie

Figur 9      ein Signaldiagramm der in Figur 7 gezeigten Mikroprozessorschaltung

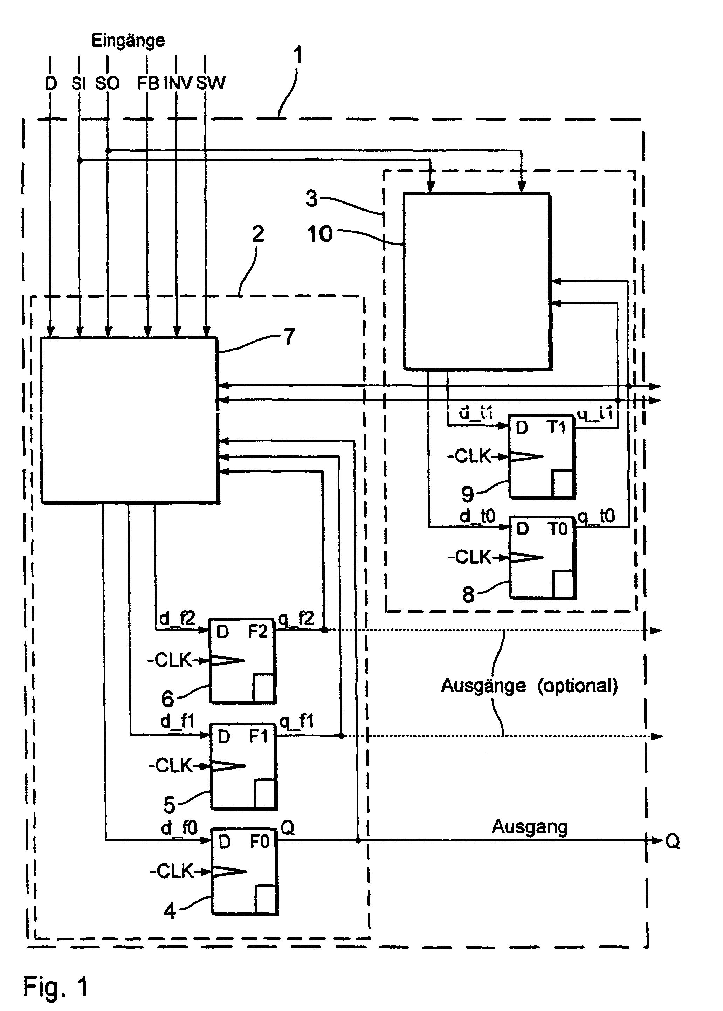

Das in Figur 1 dargestellte Blockschaltbild zeigt ein erfindungsgemäßes Schieberegister 1 mit einer Datentiefe von $d_{MAX}=3$ Bit und einer Datenbreite von einem Bit, wobei die Dateneingabe seriell über einen binären Dateneingang D erfolgt, während zur Datenausgabe ein ebenfalls serieller Datenausgang Q vorgesehen ist.

Das Einlesen der Daten in das Schieberegister 1 wird hierbei durch einen binären Steuereingang SI (Shift In Enable) gesteuert, der low-aktiv ist, so daß das Schieberegister 1 bei einem auf logisch Null liegenden Pegel des Steuersignals SI bei einer steigenden Flanke des Taktsignals das am Dateneingang D anliegende Datenbit (0 oder 1) aufnimmt, woraufhin sich der Füllungszustand des Schieberegisters 1 um ein Bit erhöht.

Die Datenausgabe wird dagegen durch ein anderes, ebenfalls low-aktives Steuersignal SO (Shift Out Enable) bewirkt, so daß bei einem auf logisch Null liegenden Pegel des Steuersignals SO bei einer steigenden Flanke des Taktsignals das ausgangsseitig gespeicherte Datenbit über den Datenausgang Q ausgetragen und damit gelöscht wird, woraufhin sich der Füllungszustand des Schieberegisters 1 um ein Bit verringert und sämtliche Datenbits um eine Stelle in Richtung Ausgang Q verschoben werden.

Aus der getrennten Steuerung von Dateneingabe und Datenausgabe folgt, daß der Füllungszustand des Schieberegisters 1 im Betrieb schwanken kann. Beträgt der Füllungszustand des Schieberegisters 1 beispielsweise zunächst drei Bit, was einem vollständig gefüllten Schieberegister 1 entspricht, und werden anschließend zwei Bits ausgetragen, während lediglich ein Bit neu eingelesen wird, so ist der Füllungszustand anschließend nur noch zwei Bit. Es ist somit erforderlich, den aktuellen Füllungszustand des Schieberegisters 1 zu speichern, um ein aufgenommenes Datenbit in Abhängigkeit vom Füllungszustand an der richtigen Stelle zu speichern. Bei der vorgegebenen Datentiefe von drei Bit sind zur Speicherung des Füllungszustands ganzzahlig aufgerundet $\log_2 (d_{MAX}+1)=2$ binäre Speicherelemente erforderlich, da insgesamt vier verschiedene Füllungszustände auftreten können.

Zur Speicherung der Datenbits sind bei einer Datentiefe von $d_{MAX}=3$ Bit zusätzlich drei binäre Speicherelemente erforderlich, so daß im vorliegenden Fall insgesamt fünf binäre Speicherzellen benötigt werden.

Das dargestellte Schieberegister 1 hält die Datenbits getrennt von dem Füllungszustand im Datenmodul 2 in den Speicherzellen 4, 5, 6. Der Füllungszustand wird dagegen in zwei Bit kodiert im Kontrollmodul 3 in den Speicherzellen 8, 9 gespeichert.

Die Kodierung der Datenbits und des Füllungszustands ist detailliert in der folgenden Tabelle dargestellt:

EP 0 942 434 B1

| | F0 | F1 | F2 | T0 | T1 | Q | SI, SO, FB, INV, SW | D, $\overline{SI}$, SO, FB, INV, SW | $\overline{D}$, $\overline{SI}$, SO, FB, INV, SW | SI, $\overline{SO}$, FB, INV, SW | SI, SO, $\overline{FB}$, INV, SW | SI, SO, $\overline{FB}$, $\overline{INV}$, SW | SI, SO, FB, INV, $\overline{SW}$ |
|---|---|---|---|---|---|---|---|---|---|---|---|---|---|
| $d_0s_0$ | 1 | 1 | 1 | 1 | 1 | $d_0s_0$ | $d_1s_1$ | $d_1s_0$ | $d_0s_0$ | $d_0s_0$ | $d_0s_0$ | $d_0s_0$ |
| $d_1s_0$ | 0 | 1 | 1 | 1 | 0 | $d_1s_0$ | $d_2s_1$ | $d_2s_0$ | $d_0s_0$ | $d_1s_0$ | $d_1s_1$ | $d_1s_0$ |
| $d_1s_1$ | 1 | 1 | 1 | 1 | 0 | $d_1s_1$ | $d_2s_3$ | $d_2s_2$ | $d_0s_0$ | $d_1s_1$ | $d_1s_0$ | $d_1s_1$ |
| $d_2s_0$ | 0 | 0 | 1 | 0 | 1 | $d_2s_0$ | $d_3s_1$ | $d_3s_0$ | $d_1s_0$ | $d_2s_0$ | $d_2s_1$ | $d_2s_0$ |
| $d_2s_1$ | 0 | 1 | 1 | 0 | 1 | $d_2s_1$ | $d_3s_3$ | $d_3s_2$ | $d_1s_1$ | $d_2s_2$ | $d_2s_3$ | $d_2s_2$ |
| $d_2s_2$ | 1 | 0 | 1 | 0 | 1 | $d_2s_2$ | $d_3s_5$ | $d_3s_4$ | $d_1s_0$ | $d_2s_1$ | $d_2s_0$ | $d_2s_1$ |
| $d_2s_3$ | 1 | 1 | 1 | 0 | 1 | $d_2s_3$ | $d_3s_7$ | $d_3s_6$ | $d_1s_1$ | $d_2s_3$ | $d_2s_2$ | $d_2s_3$ |
| $d_3s_0$ | 0 | 0 | 0 | 0 | 0 | $d_3s_0$ | $d_3s_0$ | $d_3s_0$ | $d_2s_0$ | $d_3s_0$ | $d_3s_1$ | $d_3s_0$ |
| $d_3s_1$ | 0 | 0 | 1 | 0 | 0 | $d_3s_1$ | $d_3s_1$ | $d_3s_1$ | $d_2s_1$ | $d_3s_2$ | $d_3s_3$ | $d_3s_1$ |
| $d_3s_2$ | 0 | 1 | 0 | 0 | 0 | $d_3s_2$ | $d_3s_2$ | $d_3s_2$ | $d_2s_2$ | $d_3s_4$ | $d_3s_5$ | $d_3s_4$ |
| $d_3s_3$ | 0 | 1 | 1 | 0 | 0 | $d_3s_3$ | $d_3s_3$ | $d_3s_3$ | $d_2s_3$ | $d_3s_6$ | $d_3s_7$ | $d_3s_5$ |
| $d_3s_4$ | 1 | 0 | 0 | 0 | 0 | $d_3s_4$ | $d_3s_4$ | $d_3s_4$ | $d_2s_0$ | $d_3s_1$ | $d_3s_0$ | $d_3s_2$ |
| $d_3s_5$ | 1 | 0 | 1 | 0 | 0 | $d_3s_5$ | $d_3s_5$ | $d_3s_5$ | $d_2s_1$ | $d_3s_3$ | $d_3s_2$ | $d_3s_3$ |
| $d_3s_6$ | 1 | 1 | 0 | 0 | 0 | $d_3s_6$ | $d_3s_6$ | $d_3s_6$ | $d_2s_2$ | $d_3s_5$ | $d_3s_4$ | $d_3s_6$ |
| $d_3s_7$ | 1 | 1 | 1 | 0 | 0 | $d_3s_7$ | $d_3s_7$ | $d_3s_7$ | $d_2s_3$ | $d_3s_7$ | $d_3s_6$ | $d_3s_7$ |

In der ersten Spalte ist hierbei die Bezeichnung $d_i s_k$ des jeweiligen Zustands aufgetragen, wobei der Index i den Füllungszustand wiedergibt und der Index k die verschiedenen möglichen Zustände bei einem Füllungszustand unterscheidet. In den nächsten drei Spalten der Tabelle sind die drei Datenbits aufgetragen, die in den Flip-Flops 4, 5, 6 gespeichert sind, wobei das ausgangsseitig gespeicherte und am Datenausgang Q erscheinende Datenbit in der zweiten Spalte und das eingangsseitige Datenbit in der vierten Spalte erscheint. Bei einem nicht vollständig gefüllten Schieberegister 1 werden die nicht gefüllten Datenbits auf "1" gesetzt, so daß beispielsweise im Initialzustand $d_0 s_0$ leeres Schieberegister) alle Datenbits auf "1" gesetzt sind, wie aus der ersten Zeile der Tabelle hervorgeht. In den Spalten fünf und sechs der Tabelle sind dann die Füllungszustands-Bits in invertierter Form aufgetragen, wobei das höherwertige Bit in Spalte fünf und das niederwertige Bit in Spalte sechs eingetragen ist. Die restlichen Spalten der Tabelle enthalten die Zustände, in die das Schieberegister 1 bei verschiedenen Werten der Steuersignale übergeht.

Neben den bereits vorstehend erwähnten Steuereingängen SI und SO weist das Schieberegister 1 weitere Steuereingänge auf, die eine Vertauschung der gespeicherten Datenbits ermöglichen.

So bewirkt der low-aktive Steuereingang FB (Feed Back Enable) eine Rückführung des ausgangsseitig gespeicherten Datenbits an den Eingang D des Schieberegisters 1, wobei die Möglichkeit besteht, das zurückgeführte Datenbit durch den low-aktiven Steuereingang INV (Invert) zusätzlich zu invertieren. Das Signal INV wird nur in Verbindung mit dem Signal FB (logisch null) wirksam. Allein aktiviert (logisch null) ändert es den Zustand des Schieberegisters 1 nicht.

Schließlich weist das Schieberegister 1 einen weiteren low-aktiven Steuereingang SW (Swap Enable) auf, der, wenn er aktiviert ist, bei einer positiven Flanke des Taktes zu einer Vertauschung der beiden ausgangsseitig gespeicherten Datenbits führt.

In der Tabelle sind nur die Grundfunktionen des Schieberegisters 1 aufgezeigt, bei denen mit Ausnahme von FB, INV jeweils nur ein Steuersignal aktiviert (logisch null) wird. Werden mehrere Steuersignale gleichzeitig aktiviert, so läßt sich der Folgezustand auch aus der Tabelle entnehmen in dem man die Grundfunktionen für die aktivierten Signale in folgender Reihenfolge ausführt:

    1. FB,INV (bzw. FB,INV),
    2. SW
    3. SO,
    4. SI.

Das Schieberegister 1 führt die Gesamtheit aller aktivierten Funktionen in einem Takt aus, da alle Funktionen vor den Speicherelementen durch ein asynchrones Schaltnetz (Logikschaltung 7) gemäß Fig. 1 realisiert werden.

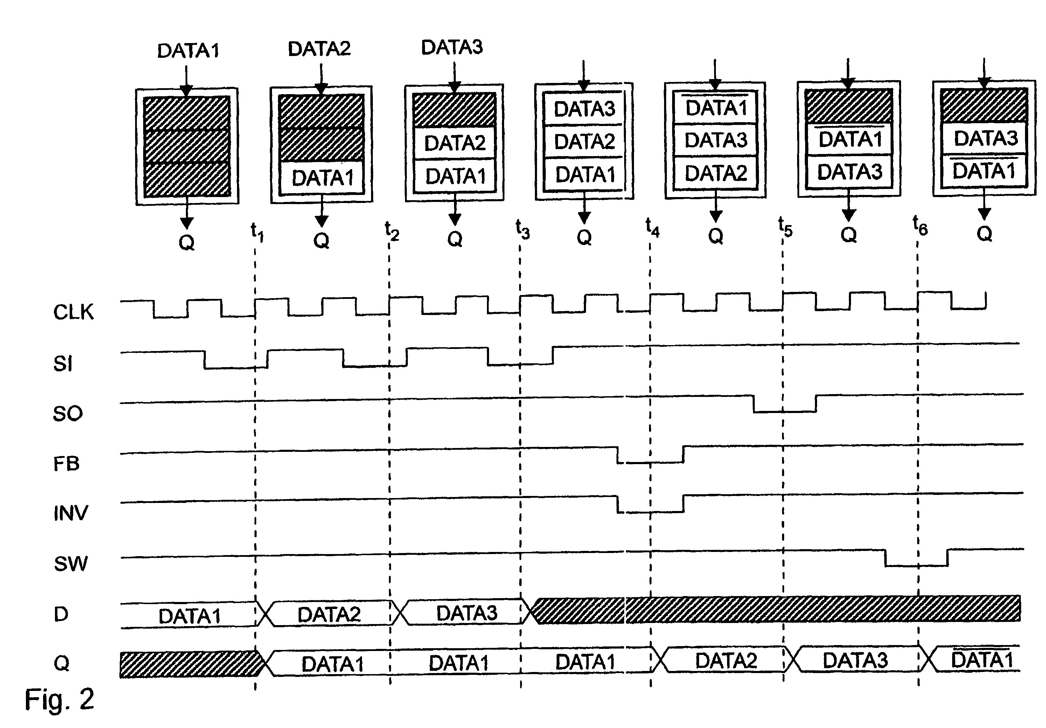

Im folgenden wird das Verhalten des Schieberegisters 1 anhand des in Figur 2 dargestellten Signaldiagramms eingehend beschrieben. Oberhalb des Signaldiagramms ist hierbei jeweils der aktuelle Zustand des Schieberegisters 1 dargestellt, wobei nicht gefüllte Speicherzellen schraffiert sind.

Bis zum Zeitpunkt $t_1$ befindet sich das Schieberegister 1 im Initialzustand, d.h. der Füllungszustand des Schieberegisters 1 ist null und sämtliche Speicherelemente sind entsprechend schraffiert dargestellt. Bei der steigenden Flanke des Taktsignals CLK im Zeitpunkt $t_1$ ist das Steuersignal SI dann logisch null, so daß das Eingangssignal DATA1 in das Schieberegister 1 übernommen wird und sofort in das ausgangsseitige Speicherelement geschrieben wird, da alle Speicherelemente zuvor leer waren. Entsprechend erscheint das aufgenommene Signal DATA1 sofort am Datenausgang Q. Bei der nächsten steigenden Flanke des Taktsignals CLK zwischen den Zeitpunkten $t_1$ und $t_2$ sind alle low-aktiven Steuereingänge auf logisch eins, so daß der Zustand des Schieberegisters 1 unverändert bleibt.

Bei der steigenden Flanke des Taktsignals CLK im Zeitpunkt $t_2$ ist das Steuersignal SI dann wieder logisch null, so daß das neue Eingangssignal DATA2 in das Schieberegister übernommen wird und in das mittlere Speicherelement geschrieben wird, da das ausgangsseitige Speicherelement bereits mit dem zuvor im Zeitpunkt $t_1$ aufgenommenen Eingangssignal DATA1 gefüllt ist. Da zum Zeitpunkt $t_2$ keine Daten aus dem Schieberegister 1 herausgeschoben werden, erscheint am Datenausgang Q weiterhin das Signal DATA1.

Zum Zeitpunkt $t_3$ ist das Steuersignal SI wiederum logisch null, woraufhin das Eingangssignal DATA3 aufgenommen und in dem eingangsseitigen Speicherelement festgehalten wird. Am Datenausgang Q erscheint weiterhin das Signal DATA1, da keine Daten aus dem Schieberegister 1 herausgeschoben wurden. Nach dem Zeitpunkt $t_3$ ist das Schieberegister 1 also zunächst vollständig mit Daten gefüllt.

Bei der steigenden Flanke des Taktsignals CLK im Zeitpunkt $t_4$ sind dann sowohl das Steuersignal FB als auch das Steuersignal INV logisch null, woraufhin das ausgangsseitig gespeicherte Signal DATA1 an den Eingang des Schieberegisters 1 zurückgeführt und dabei gleichzeitig invertiert wird. Hierbei wird das zuvor in dem mittleren Speicherelement gespeicherte Signal DATA2 in Richtung Ausgang Q verschoben, so daß nunmehr das Signal DATA2 am Ausgang Q erscheint.

Im Zeitpunkt $t_5$ ist dann das Steuersignal SO logisch null, wodurch das ausgangsseitig gespeicherte Signal DATA2 aus dem Schieberegister 1 herausgeschoben wird, woraufhin die eingangsseitigen Signale in Richtung Ausgang verschoben werden. Am Ausgang Q erscheint nun das Signal DATA3, während das eingangsseitige Speicherelement leer ist, so daß der Füllungszustand des Schieberegisters 1 nur noch zwei Bit beträgt.

Die steigende Flanke des Taktsignals CLK im Zeitpunkt $t_6$ führt dann zu einer Vertauschung der beiden ausgangsseitigen Signale, da das Steuersignal SW zu diesem Zeitpunkt logisch null ist.

Das vorstehend beschriebene Verhalten des Schieberegisters 1 wird durch die Logikschaltungen 7 und 10 bewirkt, die eingangsseitig mit den Ausgängen FO, F1, F2, TO und T1 der fünf Flip-Flops 4, 5, 6, 8, 9, mit dem Dateneingang D und mit den Steuereingängen SI, SO, FB, INV, SW verbunden ist.

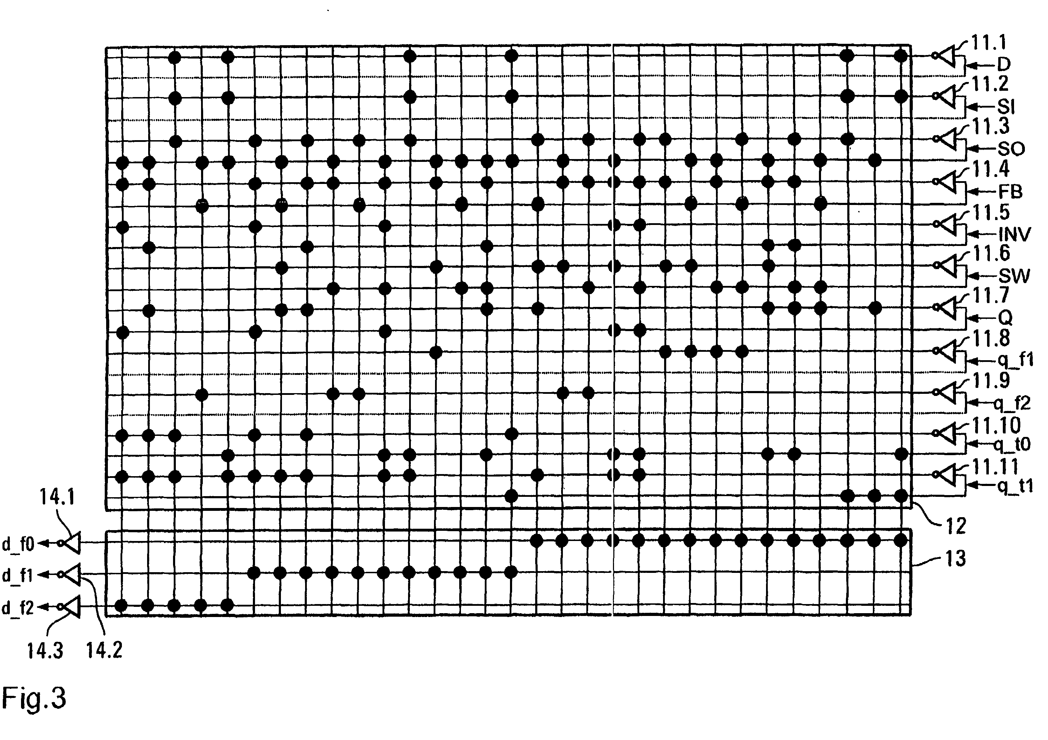

Die Logikschaltung 7 des Datenmoduls 2 ist detailliert in Figur 3 dargestellt und hat die Aufgabe, aus den Ausgangssignalen der drei Daten-Flip-Flops 4, 5, 6 und den Ausgängen q_t0 und q_t1 des Kontrollmoduls 3 zusammen mit dem Dateneingang D und den Steuereingängen SI, SO, FB, INV, SW den verschiedenen Zuständen entsprechende Eingangssignale für die drei Daten-Flip-Flops 4, 5, 6 zu dekodieren. Bei einer EPLD-Implementierung weist die Logikschaltung 7 hierzu elf Inverter 11.1-11.11, eine UND-Matrix 12 und eine ODER-Matrix 13 auf, die Verknüpfungen der Eingangssignale D, SI, SO, FB, INV, SW, q_t0, q_t1 und der Flip-Flop Ausgangssignale FO, F1, F2 vornehmen und die D-Eingänge der drei Daten-Flip-Flops 4, 5, 6 über drei Inverter 14.1-14.3 ansteuern. Die Verknüpfung für die D-Eingänge der drei Datenbit-Flip-Flops 4, 5, 6 erfolgt nach folgenden logischen Gleichungen

$$\overline{d\_f2} = q\_t0 \cdot \overline{q\_t1} \cdot SO \cdot \overline{SI} \cdot \overline{D}$$

$$+ \overline{q\_f2} \cdot FB \cdot SO$$

$$+ \overline{q\_t0} \cdot \overline{q\_t1} \cdot \overline{SO} \cdot \overline{SI} \cdot \overline{D}$$

$$+ \overline{Q} \cdot \overline{q\_t0} \cdot \overline{q\_t1} \cdot \overline{FB} \cdot INV \cdot SO$$

$$+ \overline{Q} \cdot \overline{q\_t0} \cdot \overline{q\_t1} \cdot \overline{FB} \cdot \overline{INV} \cdot SO$$

$$\overline{d\_f1} = \overline{q\_t0} \cdot q\_t1 \cdot SO \cdot \overline{SI} \cdot \overline{D}$$

$$+ \overline{Q} \cdot q\_t0 \cdot \overline{FB} \cdot INV \cdot SW \cdot SO$$

$$+ \overline{q\_f1} \cdot FB \cdot SW \cdot SO$$

$$+ \overline{q\_f1} \cdot \overline{FB} \cdot \overline{SW} \cdot SO$$

$$+ q\_t0 \cdot \overline{q\_t1} \cdot \overline{SO} \cdot \overline{SI} \cdot \overline{D}$$

$$+ Q \cdot q\_t0 \cdot \overline{q\_t1} \cdot \overline{FB} \cdot \overline{INV} \cdot SW \cdot SO$$

$$+ \overline{q\_f2} \cdot FB \cdot \overline{SO}$$

$$+ \overline{q\_f2} \cdot \overline{FB} \cdot SW \cdot SO$$

$$+ \overline{Q} \cdot \overline{q\_t0} \cdot \overline{q\_t1} \cdot \overline{FB} . INV \cdot \overline{SO}$$

$$+ \overline{Q} \cdot \overline{q\_t1} \cdot FB \cdot \overline{SW} \cdot SO$$

$$+ Q \cdot \overline{q\_t0} \cdot \overline{q\_t1} \cdot \overline{FB} \cdot \overline{INV} \cdot SO$$

$$\overline{d\_f0} = q\_t0 \cdot q\_t1 \cdot \overline{SI} \cdot \overline{D}$$

$$+ \overline{Q} \cdot q\_t1 \cdot SO$$

$$+ q\_t1 \cdot \overline{SO} \cdot \overline{SI} \cdot \overline{D}$$

$$+ \overline{Q} \cdot FB \cdot SW \cdot SO$$

$$+ \ \overline{Q} \cdot q\_t0 \cdot \overline{FB} \cdot INV \cdot SW \cdot \overline{SO}$$

$$+ \ \overline{Q} \cdot q\_t0 \cdot \overline{FB} \cdot INV \cdot \overline{SW} \cdot SO$$

$$+ \ \overline{q\_f1} \cdot FB \cdot SW \cdot \overline{SO}$$

$$+ \ \overline{q\_f1} \cdot \overline{FB} \cdot SW \cdot SO$$

$$+ \ \overline{q\_f1} \cdot FB \cdot \overline{SW} \cdot SO$$

$$+ \ \overline{q\_f1} \cdot FB \cdot \overline{SW} \cdot \overline{SO}$$

$$+ \ Q \cdot q\_t0 \cdot \overline{q\_t1} \cdot \overline{FB} \cdot \overline{INV} \cdot SW \cdot \overline{SO}$$

$$+ \ Q \cdot q\_t0 \cdot \overline{q\_t1} \cdot \overline{FB} \cdot \overline{INV} \cdot \overline{SW} \cdot SO$$

$$+ \ \overline{q\_f2} \cdot \overline{FB} \cdot SW \cdot \overline{SO}$$

$$+ \ \overline{q\_f2} \cdot \overline{FB} \cdot \overline{SW} \cdot SO$$

$$+ \ \overline{Q} \cdot \overline{q\_t1} \cdot FB \cdot \overline{SW} \cdot \overline{SO}$$

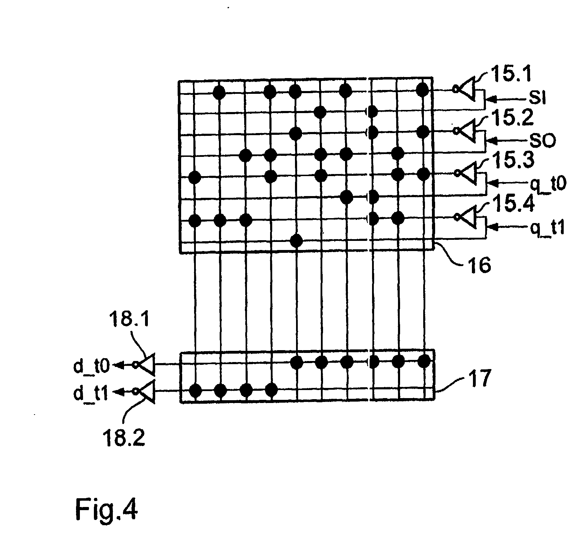

Die Logikschaltung 10 des Kontrollmoduls 3 ist detailliert in Figur 4 dargestellt und hat die Aufgabe, aus den Ausgangssignalen der zwei Füllungszustands-Flip-Flops 8, 9 zusammen mit den Steuereingängen SI, SO, FB, SW den verschiedenen Zuständen entsprechende Eingangssignale für die zwei Füllungszustands-Flip-Flops 8, 9 zu dekodieren. Bei einer EPLD-Implementierung weist hierzu die Logikschaltung vier Inverter 15.1-15.4, eine UND-Matrix 16 und eine ODER-Matrix 17 auf, die Verknüpfungen der Eingangssignale SI, SO, FB, SW und der Flip-Flop Ausgangssignale TO und TI vornehmen und die D-Eingänge der zwei Füllungszustands-Flip-Flops 8, 9 über zwei Inverter 18.1, 18.2 ansteuern.

Die Verknüpfung für die D-Eingänge der zwei Füllungszustands-Flip-Flops 8, 9 erfolgt nach folgenden logischen Gleichungen:

$$\overline{d\_t0} = \overline{SI} \cdot \overline{SO} \cdot q\_t0$$

$$+ \ SO \cdot \overline{q\_t0} \cdot \overline{q\_t1}$$

$$+ \ SI \cdot \overline{SO} \cdot q\_t0 \cdot \overline{q\_t1}$$

$$+ \ \overline{SI} \cdot SO \cdot q\_t0$$

$$+ \ SI \cdot SO \cdot \overline{q\_t0}$$

$$+ \ \overline{SI} \cdot \overline{SO} \cdot q\_t1$$

$$\overline{d\_t1} = \overline{q\_t0} \cdot SO \cdot \overline{SI}$$

$$+ \ \overline{q\_t1} \cdot SO$$

$$+ \ \overline{q\_t1} \cdot \overline{SI}$$

$$+ \ \overline{q\_t0} \cdot \overline{q\_t1}$$

Da die logischen Gleichungen für den reinen Füllungszustand unabhängig von den Ausgangssignalen des Datenmoduls 2 und dem Dateneingang D sind, brauchen bei einer Kaskadierung mehrerer Schieberegister 1 für mehrere Datenbits nur die Datenmodule 2 vervielfacht zu werden. Das Kontrollmodul 3 wird dagegen nur einmal erzeugt, wobei dessen Ausgänge q_t0 und q_t1 von allen Datenmodulen 2 gemeinsam genutzt werden.

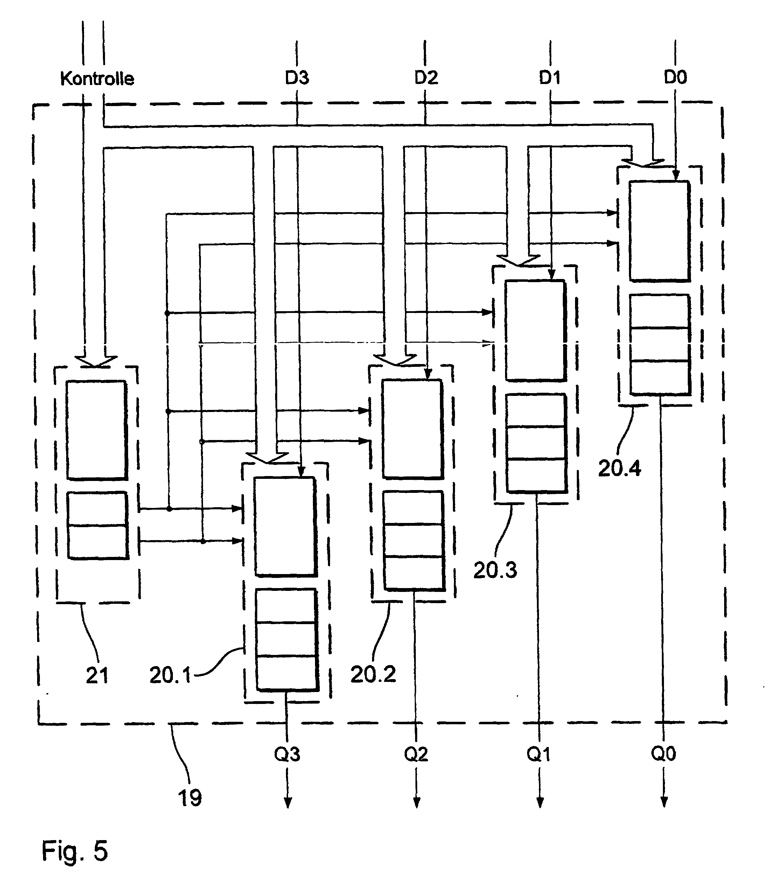

Figur 5 zeigt ein erfindungsgemäßes Schieberegister 19 mit einer Datentiefe von drei Bit und einer Datenbreite von vier Bit, das in einfacher weise durch Parallelschaltung von vier Datenmodulen 20.1 bis 20.4 des Schieberegisters 1 und einem Kontrollmodul 21 des Schieberegisters 1 gebildet wird.

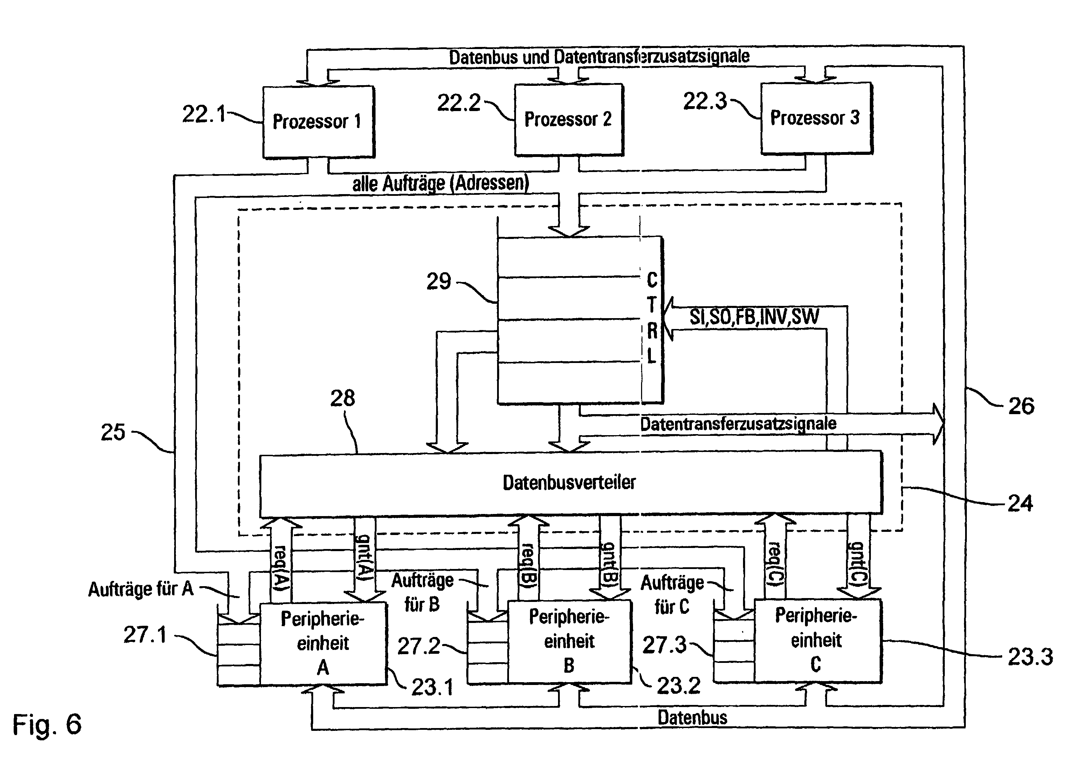

Figur 6 zeigt schließlich einen Mehrprozessorknoten mit drei Prozessoren 22.1, 22.2, 22.3 und drei Peripherieeinheiten 23.1, 23.2, 23.3 sowie einer zentralen Schnittstelle 24 zur Ermöglichung von Bustransfers im Pipeline-Verfahren zwischen den Prozessoren 22.1, 22.2, 22.3 und den Peripherieeinheiten 23.1, 23.2, 23.3. Die Bustransfers werden hierbei über einen Adreßbus 25 bzw. einen Datenbus 26 getrennt als Adreßtransfer (Auftrag) und Datentransfer durchgeführt, um hohe Bustransferraten zu erreichen und unnötige Latenzzeiten zu vermeiden. Dies führt dazu, daß die Datentransfers nicht unbedingt in derselben Reihenfolge stattfinden müssen wie die Adreßtransfers, sondern auch ungeordnet erfolgen können, was auch als Out-Of-Order-Bustransfer bezeichnet wird. Der Datenbus 26 wird hierbei derjenigen Peripherieeinheit 23.1, 23.2, 23.3 zugeteilt, die zuerst einen Datentransfer durchführen kann, auch wenn zuvor ausgegebene Aufträge für andere Peripherieeinheiten 23.1, 23.2, 23.3 noch unbearbeitet sind.

Die einzelnen Peripherieeinheiten 23.1, 23.2, 23.3 weisen jeweils eine private Auftrags-Warteschlange 27.1, 27.2, 27.3 auf, die durch ein FIFO-Schieberegister nachgebildet wird und in jedem Speicherplatz einen Auftrag enthalten kann. Bei einem Adreßtransfer gibt einer der Prozessoren 22.1, 22.2, 22.3 einen Auftrag über den Adreßbus 25 an eine der Peripherieeinheiten 23.1, 23.2, 23.3, der dort zunächst in der zugehörigen Auftrags-Warteschlange 27.1, 27.2 bzw. 27.3 abgespeichert wird. Die Peripherieeinheit 23.1, 23.2 bzw. 23.3 arbeitet dann die in der Auftrags-Warteschlange 27.1, 27.2 bzw. 27.3 gespeicherten Aufträge entsprechend ihrer Reihenfolge nacheinander ab und sendet nach dem Auslesen und der Bearbeitung eines Auftrags aus der Auftrags-Warteschlange 27.1, 27.2 bzw. 27.3 jeweils eine Anforderung req(A), req(B) bzw. req(C) an die zentrale Schnittstelle 24, damit der Peripherieeinheit 23.1, 23.2 bzw. 23.3 der für den Datentransfer erforderliche Datenbus 26 zugeteilt wird.

Für die Zuteilung des Datenbusses 26 weist die zentrale Schnittstelle 24 einen Datenbus-Verteiler 28 auf, der einerseits mit sämtlichen Peripherieeinheiten 23.1, 23.2, 23.3 und andererseits zur Übermittlung spezieller Datentransferzusatzsignale wie Tags mit dem entsprechenden Teil des Datenbusses 26 verbunden ist. Voraussetzung für die korrekte Zuordnung der Aufträge zu den auftragserteilenden Prozessoren 22.1, 22.2 bzw. 22.3 ist hierbei die Nachbildung der Auftrags-Warteschlangen 27.1, 27.2, 27.3 in der zentralen Schnittstelle 24, die normalerweise durch mehrere Auftrags-Warteschlangen erfolgt. In dem dargestellten Ausführungsbeispiel ist hierzu jedoch ein einziges Schieberegister 29 vorgesehen, das sich von dem eingangs beschriebenen Schieberegister 1 lediglich in der Datentiefe und Datenbreite unterscheidet. Die Datentiefe hängt zum einen von der Anzahl (p) der Prozessoren 22.1, 22.2 bzw. 22.3 und deren Pipeline-Fähigkeit (d) ab, d.h. wie viele Aufträge ein Prozessor ohne deren Bearbeitung ausgeben kann und zum anderen von der Tiefe der privaten Auftrags-Queues der Peripherieeinheiten 23.1, 23.2, 23.3 ab. Diese richtet sich nach der Anzahl aller möglichen unbearbeiteten Aufträge aller Prozessoren 22.1, 22.2 bzw. 22.3 (p·d), d.h. alle Prozessoren 22.1, 22.2 bzw. 22.3 schicken alle ihnen möglichen Aufträge an eine einzige der drei möglichen Peripherieeinheiten 23.1, 23.2, 23.3. Die Queue-Tiefe p·d muß jedoch nicht unbedingt eingehalten werden, wenn es einen Mechanismus gibt, die Prozessoren 22.1, 22.2 bzw. 22.3 daran zu hindern, weitere Aufträge auszugeben. Bei einem schnellen Bussytem und schnellen Peripherieeinheiten 23.1, 23.2, 23.3 ist es sehr selten der Fall, daß die Größe p·d erreicht wird. Man kann also Hardware sparen ohne größere Leistungseinbuße.

Die Datenbreite ist teilweise geringer als die der Queues in den Peripherieeinheiten 23.1, 23.2, 23.3, da keine kompletten Adressen gespeichert werden müssen; es reicht die Speicherung der Peripherieeinheitenkennung. Dafür werden jedoch andere Informationen wie Prozessorkennung und Tags gespeichert, die für die Peripherieeinheiten 23.1, 23.2, 23.3 transparent sind.

Falls die Adreßtransfers und die Datentransfers in derselben Reihenfolge durchgeführt werden, so wird das Schieberegister 29 als normales FIFO-Schieberegister betrieben, d.h. die zuerst in das Schieberegister 29 geschriebenen Aufträge werden auch zuerst ausgelesen und zur Steuerung des Datenbus-Verteilers 28 verwendet.

Bei einem Out-Of-Order-Bustransfer mit einer veränderten Reihenfolge von Datentransfers und Adreßtransfers wird dagegen auch die Reihenfolge der in dem Schieberegister 29 gespeicherten Aufträge verändert, um den richtigen Auftrag aus dem Schieberegister 29 auszulesen und den Datenbus-Verteiler 28 korrekt ansteuern zu können.

Darüber hinaus wird durch die Feedback- und Invertierungsfunktion des erfindungsgemäßen Schieberegisters 29 auch die Möglichkeit von Intervention-Transfers unterstützt, d.h. ein durch Cache-Inkonsistenz abgebrochener Leseauftrag für einen Speicher kann als Schreibauftrag wieder in das FIFO-Schieberegister 29 eingetragen werden, ohne daß ein Prozessor 22.1, 22.2 bzw. 22.3 dafür eine neue Adresse erzeugen muß.

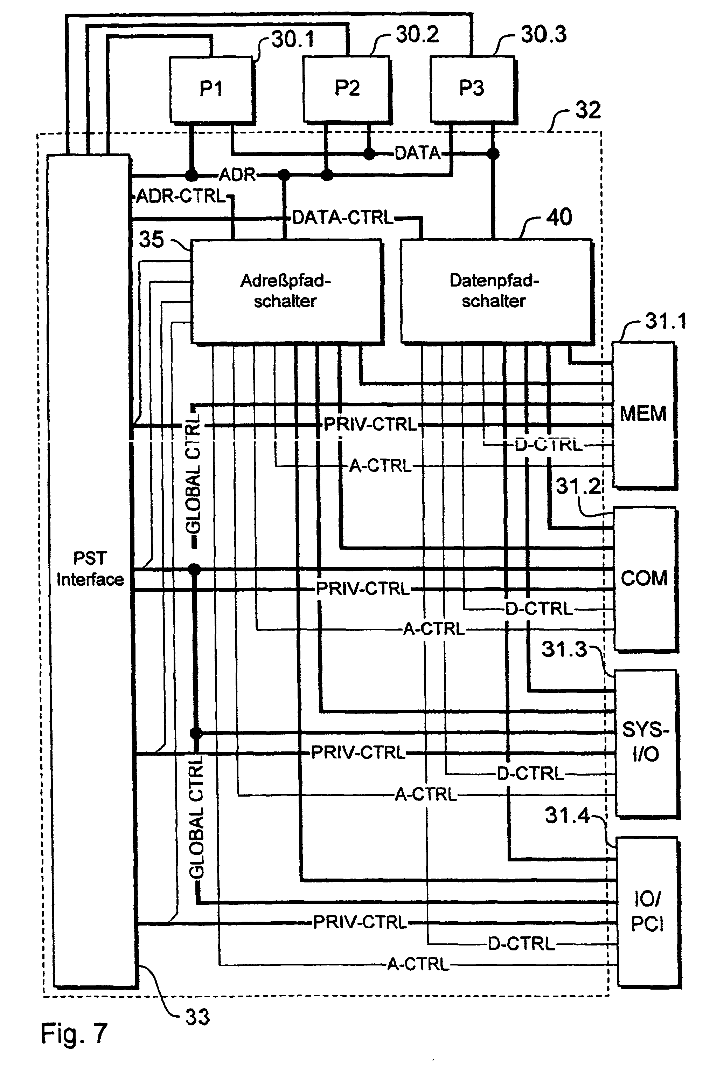

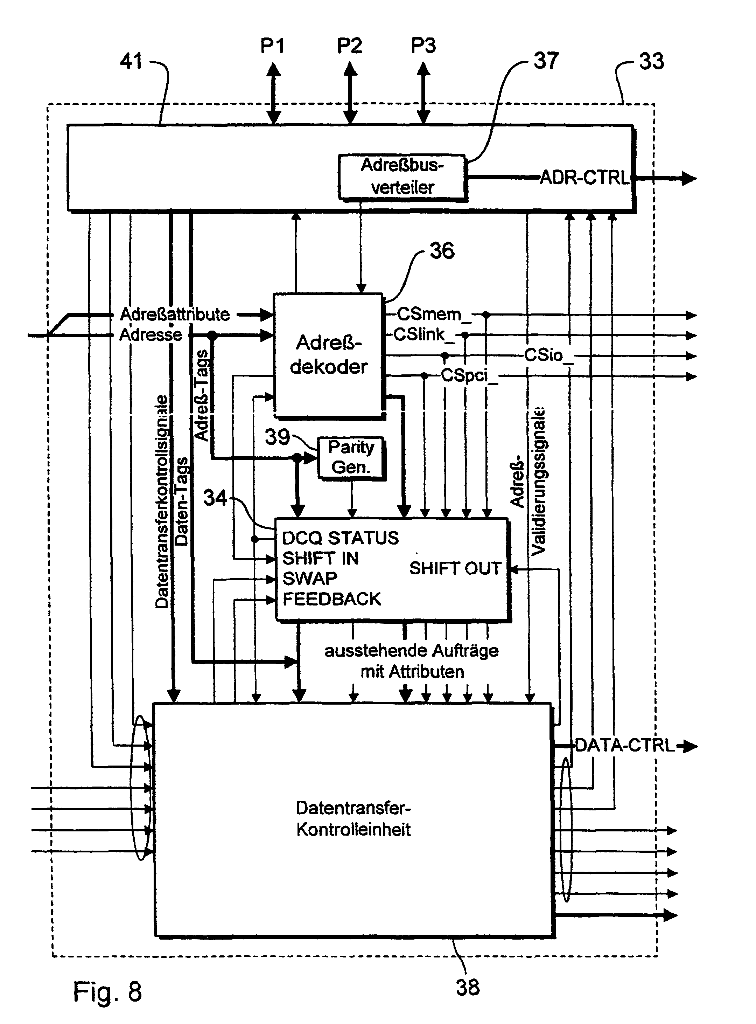

Figur 7 zeigt schließlich eine weitere Mikroprozessoranordnung mit drei Prozessoren 30.1, 30.2, 30.3 und vier Peripherieeinheiten 31.1 bis 31.4, wobei zwischen den Prozessoren 30.1 bis 30.1 und den Peripherieeinheiten 31.1 bis 31.4 eine Schnittstelle 32 angeordnet ist, die Out-Of-Order-Bustransfers ermöglicht. Hierzu ist in der Schnittstelle 32 ein sogenanntes PST-Interface 33 (PST - Pipelined Split Transaction) angeordnet, das detailliert in Figur 8 dargestellt ist.

Das PST-Interface 33 liegt zwischen den Prozessoren 30.1 bis 30.3 (aktive Einheiten) und den Peripherieeinheiten 31.1 bis 31.4 (passive Einheiten). Auf der einen Seite des Interfaces 33 werden alle zum Datentransfer benötigten Kontrollsignale der Prozessoren 30.1 bis 30.3 angeschlossen und mit den entsprechenden Protokollen abgewickelt. Auf der anderen Seite werden die Kontrollsignale für die Peripherieeinheiten 31.1 bis 31.4 angeschlossen und mittels der PST-Protokolle behandelt. Es gibt keine direkten Prozessorsignale auf der Seite der Peripherieeinheiten 31.1 bis 31.4.

Das PST-Interface 33 besitzt für alle Aufträge nur eine Generalauftragsqueue 34 (DCQ - Dynamically Configurable Queue), die dynamisch konfigurierbar ist. Für jede angeschlossene Peripherieeinheit 31.1 bis 31.4 gibt es eine private Auftragsqueue, die in einem den Adreßbus ersetzenden Adreßpfadschalter 35 untergebracht ist und nur die reinen Aufträge (frei von Ballast wie Tags und Prozessorkennung) für die angeschlossene Peripherieeinheit 31.1 bis 31.4 aufnehmen. Ohne DCQ müßten in jeder privaten Queue Tags und Prozessorkennung mitgespeichert werden. Das PST-Interface 33 verwaltet die Eintragungen von Aufträgen in diese Queues. Das Austragen aus den privaten Queues von bearbeiteten Aufträgen obliegt den Peripherieeinheiten 31.1 bis 31.4. Die Generalauftragsqueue 34 wird vom PST-Interface 33 verwaltet.

Das PST-Interface 33 besitzt einen Adreßdekoder 36, der aus den Adressen und deren Validierungssignal aus dem Adreßbusverteiler 37 Aufträge (Chip Select-Signale) für die angeschlossenen Peripherieeinheiten 31.1 bis 31.4 und Auftragsattribute, die innerhalb des Interfaces 33 benötigt werden, erzeugt, eine Snoop-Zeitüberwachung durchführt und die dazu nötigen Kontrollsignale an die DCQ 34, bzw. der Datentransferkontrolleinheit 38 zuführt. In der DCQ 34 werden mittels der Chip-Select-Signale noch nicht bearbeitete Aufträge, deren Attribute wie Lesen, Schreiben, Mehrfachtransfer und Snoop-Zyklus sowie Tags mit deren Parity-Bit, welches durch einen vorgeschalteten Parity-Generator 39 gebildet wird, gespeichert und für die angeschlossene Datentransferkontrolleinheit 38 bereitgestellt. Darüber hinaus besitzt das PST-Interface 33 in der Datentransferkontrolleinheit 38 einen Datenbusverteiler, einen Auftragsmonitor, der Vertauschungen in der DCQ 34 entsprechend den Anforderungen der Peripherieeinheiten 31.1 bis 31.4 steuert, einen Byte-Dekoder für speicherähnliche Peripherieeinheiten, einen Mehrfachtransferzähler und eine Transferzeitüberwachung, die die Zeit zwischen Auftragserteilung und Auftragsfertigstellung (Datenbusanforderung) überwacht und beim Überschreiten einer fest eingestellten Zeit einen Interrupt an den auftragserteilenden Prozessor ausgibt und den Datenbusverteiler anweist, den ausstehenden Datentransfer zu beenden. Der Datenbusverteiler teilt den Datenbus entsprechend den Anforderungen der Peripherieeinheiten 31.1 bis 31.4 und Prozessoren 30.1 bis 30.3 zu, steuert die übrigen Kontrollsignale der DCQ 34 und einen den Datenbus ersetzenden Datenpfadschalter 40.

Der Byte-Dekoder stellt für speicherähnliche Einheiten bei der Busfreigabe für Schreibzyklen die in Adresse und deren Attributen kodierten zu verändernden Bytes in dekodierter Form zur Verfügung.

Alle Einheiten des PST-Interfaces 33 sind aus endlichen Zustandsautomaten gebildet worden und zusammen mit dem Prozessor-Interface 41 in zwei EPLDs mit je 256 logischen Makrozellen untergebracht.

Für das PST-Interface 33 werden die Kontrollsignale für die passiven Peripherieeinheiten 31.1 bis 31.4, wie Speicher 31.1, Kommunikationseinheiten 31.2 und I/0-Schnittstellen 31.3, 31.4 und deren Protokolle beschrieben. Es wird beschrieben, wann und warum die entsprechenden Kontrollsignale ein- bzw. ausgeschaltet werden, welche Aktionen sie auslösen und welche Reaktionen erwartet werden. Alle Signalprotokolle sind unabhängig vom Prozessortyp. Auch alle Interface-Signale sind unabhängig vom Prozessortyp.

Die Anzahl bestimmter Interface-Signale, die zu einem Bus zusammengefaßt werden können und daher alle dem gleichen Protokoll unterliegen, ist variabel und abhängig vom jeweiligen Entwicklungsstand der Prozessoren 30.1 bis 30.3.

Im folgenden werden die verschiedenen Kontrollsignale der Mikroprozessoranordnung beschrieben. Kontrollsignale, an deren Namen das Zeichen "-" angehängt ist, sind "0"-aktiv. Andere Signale sind entweder "1"-aktiv, wenn sie einzeln vorhanden sind oder als Summensignal zu verstehen, wenn sie als Bus angegeben sind.

Zunächst werden die globalen Signale (GLOBAL-CTRL) beschrieben, die von allen Peripherieeinheiten gemeinsam genutzt werden können. Es ist jedoch nicht notwendig, daß alle Peripherieeinheiten sie benutzen müssen, wenn sie keine Auswirkung auf das Verhalten der Einheit haben.

WRITE_:   Interface-Ausgang und Eingang aller Peripherieeinheiten 31.1 bis 31.4. Es beschreibt die Richtung des Bustransfers (0 = Schreibzyklus, 1 = Lesezyklus).

BURST_:   Interface-Ausgang und Eingang aller Peripherieeinheiten 31.1 bis 31.4. Es zeigt an, ob ein Mehrfachtransfer durchgeführt werden soll.

B_EN_[0:n]:   Interface-Bus-Ausgang und Eingang aller Peripherieeinheiten 31.1 bis 31.4. Die Zahl "n" ist abhängig von der Datenbusbreite. Für jedes Byte des zur Verfügung stehenden Datenbusses wird bei ein Byte-Enable-Signal erzeugt, welches angibt, welches Byte vom Prozessor gebraucht, bzw. von der Peripherieeinheit zu konsumieren ist. Diese Signale sind nur während aktivem $BE_{[k]}$ - gültig.

PID[O:i]: Interface-Bus-Ausgang und Eingang der Peripherieeinheiten 31.1 bis 31.4, die in einem Mehrprozessorsystem aus bestimmten Gründen (Interrupt-Behandlung) wissen müssen, von welchem Prozessor 30.1 bis 30.3 aus der Bustransfer initiiert worden ist. Dieses Signal gibt die Identifizierungsnummer des Prozessors an. Je nach Anzahl der Prozessoren 30.1 bis 30.3 in einem System ist die Zahl "i" gewählt (bei bis zu 4 Prozessoren ist i=1).

A-RETRY_: Interface-Ausgang und Eingang aller Peripherieeinheiten 31.1 bis 31.4. Es zeigt an, daß ein bereits initiierter Buszyklus abgebrochen worden ist. Dieses Signal ist nur während aktivem $BE_{[k]\_}$ gültig.

S-RETRY_: Interface-Ausgang und Eingang aller Speichereinheiten 31.2. Es zeigt an, daß ein bereits initiierter Buszyklus auf Grund eines "Snoop-Hits" abgebrochen worden ist. Dieses Signal ist nur während aktivem $BE_{[k]\_}$ gültig.

INTERV_: Interface-Ausgang und Eingang aller Speichereinheiten 31.2. Es zeigt an, daß dieser Buszyklus abgebrochen und anschließend als Intervention-Zyklus durchgeführt werden soll. Dieses Signal ist nur während aktivem $BE_{[k]\_}$ gültig.

Weiterhin werden in der Mikroprozessoranordnung die nachfolgenden beschriebenen lokalen Kontrollsignale (PRIV-CTRL) verwendet, die jeweils nur von bestimmten Peripherieeinheiten genutzt werden können. Die Indizes "k" bezeichnen nachfolgend jeweils die zugehörige Peripherieeinheit.

$AP\_A_{[k]}$ [0:31]: Adresse für die Peripherieeinheit k. Sie wird mittels spezieller Adreßpfadschalter mit Speicherfunktion (FIFOs) von den Prozessoren 30.1 bis 30.3 entkoppelt und für die Peripherieeinheit k bereitgestellt.

$CS_{[k]\_}$: Interface-Ausgang und Eingang der Peripherieeinheit "k". Es zeigt dieser Einheit an, daß zwischen einem Prozessor und dieser Einheit ein Buszyklus initiiert worden ist.

$ACK_{[k]\_}$: Interface-Eingang und Ausgang der Peripherieeinheit "k". Es zeigt der Interface-Einheit an, daß die Peripherieeinheit "k" bereit ist, je nach Transferrichtung Daten vom Datenbus zu übernehmen oder auf den Datenbus zu legen.

$BE_{[k]\_}$: Interface-Ausgang und Eingang der Peripherieeinheit "k". Es zeigt dieser Einheit an, daß sie im Lesefall Daten für den Lesetransfer bereitstellen muß oder im Schreibfall Daten vom Datenbus übernehmen muß.

$SOE_{[k]\_}$: Adreßpfadschaltereingang und Ausgang der Peripherieeinheit "k". Es bewirkt das Austragen eines Auftrags aus dem FIFO des Adreßpfadschalters.

Neben den vorstehend beschriebenen globalen und privaten Signalen verwendet die Mikroprozessorschaltung auch Hilfssignale, die jedoch nicht unbedingt von den Peripherieeinheiten 31.1 bis 31.4 genutzt werden müssen, da sie sich diese Signale aus den bereits vorhandenen selbst erzeugen können. Sie können aber hilfreich sein, wenn man sie bei der Entwicklung der Peripherieeinheiten 31.1 bis 31.4 gleich miteinbezieht. Es kann dabei Entwicklungsaufwand gespart werden. Als Hilfssignale sind vorgesehen:

DP_WRITE_: Interface-Ausgang. Es zeigt die Transferrichtung für die Datentransferphase an. Dieses Signal ist nur während aktivem $BE_{[k]\_}$ gültig.

DP_BURST_: Interface-Ausgang. Es zeigt für die Datentransferphase an, ob der Transfer als Mehrfachtransfer durchgeführt werden soll. Dieses Signal ist nur während aktivem $BE_{[k]\_}$ gültig.

EOB_: Interface-Ausgang. Es zeigt in der Datentransferphase an, wann ein Mehrfachtransfer beendet ist. Dieses Signal ist nur während aktivem $BE_{[k]}$ - gültig.

Nachfolgend werden nun die Kontrollsignalprotokolle beschrieben, die sich in Auftragstransferprotokoll einerseits und Datentransferprotokoll andererseits einteilen lassen.
Das Auftragstransferprotokoll beschreibt alle Aktivitäten, die nötig sind, Aufträge an Peripherieeinheiten 31.1 bis 31.4 weiterzuleiten. Ein Auftrag für eine Peripherieeinheit besteht aus einer Adresse, der Transferrichtung (lesen, schreiben), der Transferart (Mehrfach-, Einzeltransfer) und gegebenenfalls aus der Prozessornummer des Prozessors, der den Auftrag erteilt hat. Es können mehrere Aufträge nacheinander erteilt werden, ohne daß vorhergehende Aufträge mittels Datentransfer ausgeführt oder abgeschlossen worden sind.

Ein Auftragstransfer wird der Peripherieeinheit "k" durch das Signal $CS_{[k]\_}$ angezeigt. Gleichzeitig mit $CS_{[k]\_}$ wird die Peripherieadresse im Adreßpfadschalter 35 in einem FI-FO, welches der Einheit k zugeordnet ist, gespeichert. Die Signale BURST-, WRITE- und ggf. PID[O:i] werden parallel dazu in einem der Peripherieeinheit zugeordnetem FIFO gespeichert. Der Auftragstransfer dauert einen Takt und ist mit dem Abschalten des Signals $CS_{[k]\_}$ beendet. Alle Signale werden synchron erzeugt und müssen synchron behandelt werden. Weitere Auftragstransfers können wie oben beschrieben in den entsprechenden FIFOs eingetragen werden. Damit diese FIFOs nicht überlaufen können, ist eine maximale Anzahl von aufeinanderfolgenden Auftragstransfers festgelegt. Ist dieses Maximum erreicht, so wird vom PST-Interface 33 kein weiterer Auftrag zugelassen. Dieses geschieht mittels Retry-Mechanismen auf der Prozessorseite des Interfaces 33. Die Peripherieeinheit merkt davon nichts. Nachdem ein Auftrag in den der Peripherieeinheit 31.1 bis 31.4 zugeordneten FIFOs eingetragen ist, beginnt die Peripherieeinheit 31.1 bis 31.4 mit der Bearbeitung, d. h. es werden je nach Transferrichtung die gewünschten Daten bereitgestellt oder die Übernahme von Daten vorbereitet. Danach wird nach dem Datentransferprotokoll eine Datenübertragung vorgenommen. Wenn die Auftragsparameter nicht mehr gebraucht werden, so wird dieser Auftrag von der Peripherieeinheit 31.1 bis 31.4 aus dem FIFO ausgetragen und die Bearbeitung eines eventuell nachfolgend eingetragenen Auftrags begonnen.

Jede Peripherieeinheit 31.1 bis 31.4 muß sich die Anzahl der Aufträge, die durch $CS_{[k]\_}$ eingeleitet werden, speichern. Mit jedem $CS_{[k]\_}$ erhöht sich diese Anzahl um 1, und mit jedem Austragen aus dem FIFO mittels $SOE_{[k]\_}$ verringert sich die Anzahl um 1. Ist diese Anzahl 0, so liegt kein Auftrag vor.

Das Datentransferprotokoll beschreibt alle Aktivitäten, die nötig sind, Daten zwischen aktiven Einheiten (Prozessoren 30.1 bis 30.3) und passiven Peripherieeinheiten 31.1 bis 31.4 (Speicher, Kommunikationseinheiten, I/0) auszutauschen. Ein Datentransfer kann ein Einzeltransfer variabler Datenbreite oder ein Mehrfachtransfer mit mehreren Datenworten der vollen Datenbusbreite sein. Ein Datentransfer kann auch unter bestimmten Bedingungen abgebrochen werden. Den meisten Datentransfers geht ein Auftragstransfer voraus, es gibt jedoch auch Datentransfers, denen kein separater Auftrag vorausgegangen ist (Intervention). Auch dieser Transfer ist mittels des Datentransferprotokolls ausführbar.

Das Datentransferprotokoll beginnt nach der Bereitstellung von Daten (lesen) oder nach der Vorbereitung zur Übernahme von Daten (schreiben). Die Peripherieeinheit 31.1 bis 31.4 signalisiert das in beiden Fällen durch das synchrone Signal $ACK_{[k]}$. Wird dieses Signal vom PST-Interface 33 erkannt, so werden eventuelle Konflikte mit anderen Datentransfers mittels eines Datenbus-Dispatchers innerhalb des PST-Interfaces 33 gelöst und der Datenbus zwischen der Peripherieeinheit 31.1 bis 31.4 und dem zugeordnetem Prozessor freigeschaltet. Die Freischaltung des Datenbusses wird der Peripherieeinheit 31.1 bis 31.4 durch das synchrone Signal $BE_{[k]\_}$ angezeigt. Wird dieses Signal von der Peripherieeinheit 31.1 bis 31.4 erkannt, so muß sie im nächsten Takt die Daten für den Bustransfer bereitstellen (lesen) oder vom Datenbus übernehmen (schreiben). Gleichzeitig mit dem Signal $BE_{[k]\_}$ werden die Byte-Select-Signale B_EN_[O:n] und die Signale DP_WRITE_ und ggf. das Signal DP_BURST_ vom PST-Interface 33 erzeugt. Beim Lesen sind alle Byte-Select-Signale aktiviert, beim Schreiben nur die der wirklich zu beschreibenden Bytes. Bei einem Mehrfachtransfer wird zusätzlich das Signal DP_BURST_ erzeugt. Bei diesem Transfer muß in jedem Takt, je nach der Definition der Burst-Länge, ein Datenwort der vollen Busbreite übernommen bzw. für den Bustransfer bereitgestellt werden. Das Ende des Mehrfachtransfers wird einen Takt vorher durch das Signal EOB_ angezeigt. Das Signal $BE_{[k]\_}$ ist bei einem Mehrfachtransfer bis zum vorletzten Takt dieses Transfers aktiviert. Das Signal $ACK_{[k]\_}$ muß mindestens solange eingeschaltet bleiben, bis das Signal $BE_{[k]\_}$ erkannt wird. Bei einem Einzeltransfer muß es dann sofort (synchron) abgeschaltet werden. Bei einem Mehrfachtransfer darf es bis zum vorletzten Takt dieses Transfers eingeschaltet bleiben. Bei von den Prozessoren initiierten Abbrüchen eines Transfers können gleichzeitig mit dem Signal $BE_{[k]\_}$ die Signale A_ RETRY_, S_RETRY_ oder INTERV_ aktiv sein. Das Signal $BE_{[k]\_}$ wird dann nur einen Takt lang erzeugt (auch bei Mehrfachtransfers) und der Datenbus wird nicht freigeschaltet. Beim Erkennen der Signale A_RETRY_ oder S_RETRY_ muß der aktuelle Auftrag sofort aus den Auftrags-FIF0s mittels des Signals $SOE_{[k]\_}$ ausgetragen werden. Beim Erkennen des Signals INTERV_ (dieses gilt nur für Speicher) wird der aktuelle Auftrag vom PST-Interface 33 aus dem FI-FO ausgetragen und als Mehrfachschreibauftrag umgewandelt wieder eingetragen. Da dieser Auftrag höchste Priorität hat, ist vom PST-Interface 33 sichergestellt, daß bis zur erneuten Bearbeitung dieses Auftrags kein weiterer Auftrag in die FIFOs geschrieben wird. Eventuell noch eingetragene Aufträge müssen natürlich normal abgewickelt werden.

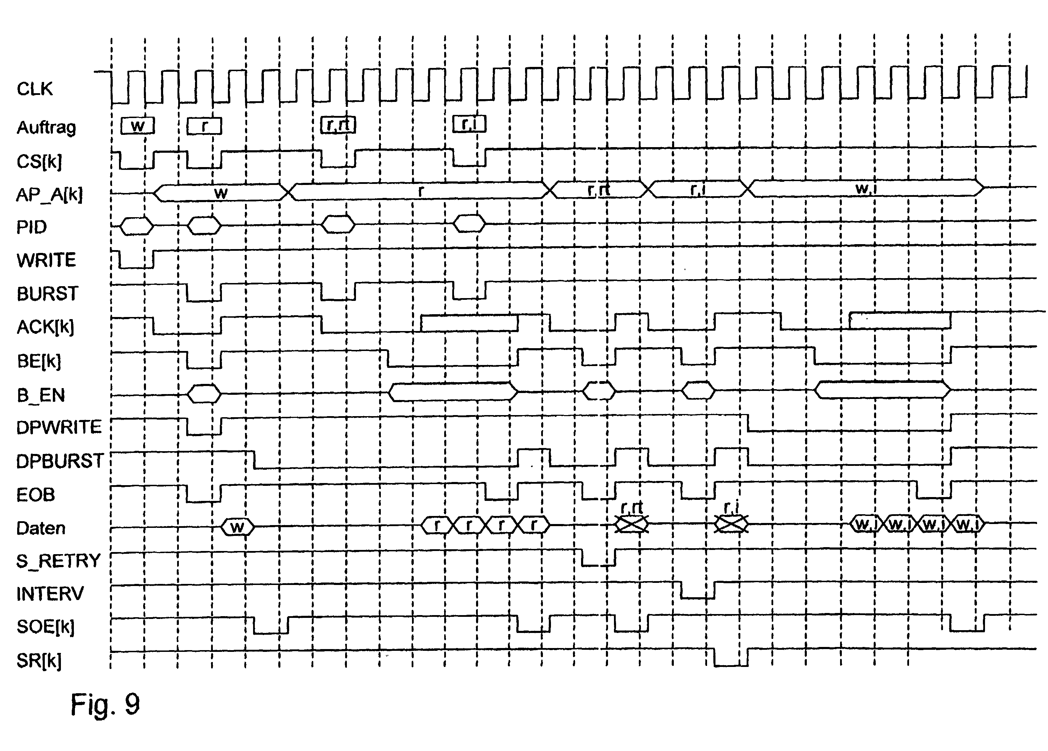

Figur 9 zeigt schließlich ein Signaldiagramm der vorstehend beschriebenen Mikroprozessoranordnung, das sich auf eine bestimmte Peripherieeinheit 31.1 bis 31.4 bezieht, die durch den Index k bezeichnet wird.

Die Aufträge sind Prozessoraufträge und sind für die angeschlossenen Einheiten nicht sichtbar. Es sind folgende Aufträge beschrieben:

w =     Schreibauftrag.

r =     Leseauftrag im Mehrfachtransfer.

r, rt =     Leseauftrag im Mehrfachtransfer, der von der Prozessorseite aus abgebrochen werden soll. Die Abbruchbedingung wird erst nach der Ausgabe des Auftrags nach einer festgesetzten Zeit übermittelt. Das PST-Interface 33 überwacht diese Zeit, und gibt den Datentransfer erst nach Ablauf dieser Zeit frei.

r, i =     Leseauftrag im Mehrfachtransfer, der von der Prozessorseite aus in einen Intervention-Zyklus umgewandelt werden soll. Auch diese Intervention-Bedingung (SnoopZeit) wird erst nach der Ausgabe des Auftrags nach einer festgesetzten Zeit übermittelt. Das PST-Interface 33 überwacht auch diese Zeit, und gibt den Datentransfer erst nach Ablauf dieser Zeit frei.

Das Signal "$SOE_{[k]\_}$" ist das Signal der Einheit k zum Austragen des Auftrags aus dem FIFO im Adreßpfadschalter 35. Das Signal "$SR_{[k]\_}$" wird vom PST-Interface erzeugt und bewirkt das Austragen und das Neueintragen des von einem Lesetransfer in einen Schreibtransfer umgewandelten Auftrags.

Die Erfindung beschränkt sich in ihrer Ausführung nicht auf die vorstehend angegebenen bevorzugten Ausführungsbeispiele. Vielmehr ist eine Anzahl von Varianten denkbar, welche von der dargestellten Lösung auch bei grundsätzlich anders gearteten Ausführungen Gebrauch macht..

**Patentansprüche**

1.  Schieberegister (1) mit

    einem Dateneingang (D) zur aufeinanderfolgenden Aufnahme mehrerer Datenbits,

    mehreren, dem Dateneingang (D) nachgeschalteten binären Speicherelementen (4, 5, 6) zur Speicherung jeweils eines der aufgenommenen Datenbits,

    einem Datenausgang (Q) zur aufeinanderfolgenden Ausgabe der einzelnen gespeicherten Datenbits sowie

    einem ersten Steuereingang (SI) zur Aufnahme eines ersten binären Steuersignals und

    einer eingangsseitig mit dem ersten Steuereingang (SI) und ausgangsseitig mit den Speicherelementen (4, 5, 6) verbundenen Steuerlogik (7), welche die Speicherelemente (4, 5, 6) bei einem vorgegebenen Wert des ersten Steuersignals zur Aufnahme eines neuen Datenbits über den Dateneingang (D) und/oder zur Abgabe eines der gespeicherten Datenbits über den Datenausgang (Q) ansteuert, und

    einer eingangsseitig mit dem ersten Steuereingang (SI) und ausgangsseitig mit den Speicherelementen (8, 9) verbundenen Steuerlogik (10), welche den in den Speicherelementen (8, 9) gespeicherten Füllungszustandswert bei einem vorgegebenen Wert des ersten Steuersignals um 1 erhöht,

    **gekennzeichnet durch**
    einen zweiten Steuereingang (SW) zur Aufnahme eines zweiten binären Steuersignals, wobei die Steuerlogik (7) eingangsseitig mit den Ausgängen (Q, q_f1, q_f2) der Speicherelemente (4, 5, 6) und dem zweiten Steuereingang (SW) verbunden ist und die Speicherelemente (4, 5, 6) bei einem vorgegebenen Wert des zweiten Steuersignals bei einem Füllungszustand von mindestens zwei zur Vertauschung der beiden ausgangsseitig gespeicherten Datenbits ansteuert.

2.  Schieberegister (1) nach Anspruch 1, **dadurch gekennzeichnet, daß** zur Aufnahme eines dritten binären Steuersignals ein dritter Steuereingang (SO) vorgesehen ist, wobei die Steuerlogik (7) eingangsseitig mit dem dritten Steuereingang (SO) verbunden ist und die Speicherelemente (4, 5, 6) bei einem vorgegebenen Wert des dritten Steuersignals zur Ausgabe eines der gespeicherten Datenbits über den Datenausgang (Q) ansteuert und die Steuerlogik (10) eingangsseitig mit dem dritten Steuersignal (SO) verbunden ist, welche den in den Speicherelementen (8, 9) gespeicherten Füllungszustandswert bei einem vorgegebenen Wert des dritten Steuersignals um 1 erniedrigt.

3.  Schieberegister (1) nach Anspruch 2, **dadurch gekennzeichnet, daß** die Zahl der binären Speicherelemente (8, 9) zur Speicherung einer den Füllungszustand wiedergebenden Zahl unabhängig von der Zahl der zu speichernden Datenbits und den dazugehörigen binären Speicherelementen (4, 5, 6) ist.

4. Schieberegister (1) nach einem der vorhergehenden Ansprüche, **gekennzeichnet durch** einen vierten Steuereingang (FB) zur Aufnahme eines vierten binären Steuersignals, wobei die Steuerlogik (7) zur Aufnahme des vierten Steuersignals eingangsseitig mit dem vierten Steuereingang (FB) verbunden ist und die Speicherelemente (4, 5, 6) bei einem vorgegebenen Wert des vierten Steuersignals zur Vertauschung des zuerst aufgenommen mit dem zuletzt aufgenommenen Datenbit ansteuert.

5. Schieberegister (1) nach Anspruch 4, **gekennzeichnet durch** einen fünften Steuereingang (INV) zur Aufnahme eines fünften binären Steuersignals, wobei die Steuerloqik (7) zur Aufnahme des fünften Steuersignals eingangsseitig mit dem fünften Steuereingang (INV) verbunden ist und die Speicherelemente bei (4, 5, 6) einem vorgegebenen Wert des fünften Steuersignals nach der Vertauschung des zuletzt aufgenommenen mit dem zuerst aufgenommenen Datenbit zur Invertierung des eingangsseitigen Datenbits ansteuert.

6. Schieberegister (1) nach einem der vorhergehenden Ansprüche, **dadurch gekennzeichnet, daß** die Speicherelemente Flip-Flops (4, 5, 6, 8, 9) sind.

7. Mikroprozessoranordnung mit
mehreren Prozessoren (22.1, 22.2, 22.3) und mehreren Peripherieeinheiten (23.1, 23.2, 23.3),
einem Adreßbus zur Übertragung von Aufträgen von den Prozessoren zu den Peripherieeinheiten,
einem Datenbus zur Übertragung von Daten von den Prozessoren zu den Peripherieeinheiten, wobei die Peripherieeinheiten (23.1, 23.2, 23.3) zur Zwischenspeicherung der übertragenen Aufträge während der Abarbeitung früherer Aufträge jeweils ein Schieberegister (27.1, 27.2, 27.3) aufweisen,
einer einerseits mit den Peripherieeinheiten (23.1, 23.2, 23.3) und andererseits mit den Prozessoren (22.1, 22.2, 22.3) verbundenen Schnittstelle (24) zur Verbindung der Prozessoren (22.1, 22.2, 22.3) mit den Peripherieeinheiten (23.1, 23.2, 23.3) für einen Datentransfer,
wobei die Schnittstelle (24) zur Zuteilung des Datenbusses (26) zu jeweils einer der Peripherieeinheiten (23.1, 23.2, 23.3) einen Datenbus-Verteiler (28, 40) aufweist und zur Speicherung der von den Prozessoren (22.1, 22.2, 22.3) abgegebenen Aufträge und zur Ansteuerung des Datenbus-Verteilers (28) entsprechend den gespeicherten Aufträgen ein mit dem Adreßbus (25) verbundenes Schieberegister (29, 34) vorgesehen ist,
**dadurch gekennzeichnet**
**daß** das zur Speicherung der Aufträge in der Schnittstelle vorgesehene Schieberegister (29, 34) ein Schieberegister nach einem der vorhergehenden Ansprüche ist, wobei die Steuereingänge des Schieberegisters (29) zur Änderung der Reihenfolge der gespeicherten Aufträge mit den Prozessoren (22.1, 22.2, 22.3) verbunden ist.

8. Mikroprozessoranordnung nach Anspruch 7, **dadurch gekennzeichnet, daß** die Schnittstelle zur Zuteilung des Adreßbusses zu einer der Peripherieeinheiten einen Adreßbus-Verteiler (35) aufweist.

9. Mikroprozessoranordnung nach Anspruch 7 oder 8, **dadurch gekennzeichnet, daß** die Schnittstelle (32) zur Ansteuerung des Datenbus-Verteilers (40) und/oder des Adreßbus-Verteilers (35) eine Steuerschaltung (33) aufweist, die eingangsseitig mit dem Adreßbus verbunden ist.

**Claims**

1. A shift register (1) comprising
    a data input (D) for successively receiving a plurality of data bits,
    a plurality of binary memory elements (4, 5, 6) connected downstream of the data input (D) for the storage of respective ones of the received data bits,
    a data output (Q) for the successive output of the individual stored data bits as well as
    a first control input (SI) for receiving a first binary control signal and
    a control logic (7) which is connected at the input side to the first control input (SI) and at the output side to the memory elements (4, 5, 6) and which actuates the memory elements (4, 5, 6) at a predetermined value of the first control signal for receiving a new data bit by way of the data input (D) and/or for the output of one of the stored data bits by way of the data output (Q), and
    a control logic (10) which is connected at the input side to the first control input (SI) and at the output side to the memory elements (8, 9) and which increases the filling state value stored in the memory elements (8, 9) by 1 at a predetermined value of the first control signal,

**characterised by**

a second control input (SW) for receiving a second binary control signal, wherein the control logic (7) is connected on the input side to the outputs (Q, q_f1, q_f2) of the memory elements (4, 5, 6) and the second control input (SW) and actuates the memory elements (4, 5, 6) at a predetermined value of the second control signal at a filling state of at least two to interchange the two data bits stored at the output side.

2. A shift register (1) according to claim 1 **characterised in that** there is provided a third control input (SO) to receive a third binary control signal, wherein the control logic (7) is connected at the input side to the third control input (SO) and actuates the memory elements (4, 5, 6) at a predetermined value of the third control signal for the output of one of the stored data bits by way of the data output (Q) and the control logic (10) is connected at the input side to the third control signal (SO) which reduces the filling state value stored in the memory elements (8, 9) by 1 at a predetermined value of the third control signal.

3. A shift register (1) according to claim 2 **characterised in that** the number of binary memory elements (8, 9) for storage of a number reproducing the filling state is independent of the number of data bits to be stored and the associated binary memory elements (4, 5, 6).

4. A shift register (1) according to one of the preceding claims **characterised by** a fourth control input (FB) for receiving a fourth binary control signal, wherein the control logic (7) is connected at the input side to the fourth control input (FB) for receiving the fourth control signal and actuates the memory elements (4, 5, 6) at a predetermined value of the fourth control signal for interchange of the first received data bit with the last received data bit.

5. A shift register (1) according to claim 4 **characterised by** a fifth control input (INV) for receiving a fifth binary control signal, wherein the control logic (7) is connected at the input side to the fifth control input (INV) to receive the fifth control signal and actuates the memory elements (4, 5, 6) at a predetermined value of the fifth signal after interchange of the last-received data bit with the first-received data bit for inversion of the input-side data bit.

6. A shift register (1) according to one of the preceding claims **characterised in that** the memory elements are flip-flops (4, 5, 6, 8, 9).

7. A microprocessor arrangement comprising

a plurality of processors (22.1, 22.2, 22.3) and a plurality of peripheral units (23.1, 23.2, 23.3),

an address bus for the transmission of tasks from the processors to the peripheral units,

a data bus for the transmission of data from the processors to the peripheral units, wherein the peripheral units (23.1, 23.2, 23.3) each have a respective shift register (27.1, 27.2, 27.3) for intermediate storage of the transmitted tasks during the processing of earlier tasks,

an interface (24) connected on the one hand to the peripheral units (23.1, 23.2, 23.3) and on the other hand to the processors (22.1, 22.2, 22.3) for connecting the processors (22.1, 22.2, 22.3) to the peripheral units (23.1, 23.2, 23.3) for a data transfer,

wherein the interface (24) has a data bus distributor (28, 40) for allocation of the data bus (26) to a respective one of the peripheral units (23.1, 23.2, 23.3) and for storage of the tasks delivered by the processors (22.1, 22.2, 22.3) and for actuation of the data bus distributor (28) in accordance with the stored tasks there is provided a shift register (29, 34) connected to the address bus (25),

**characterised in that**

the shift register (29, 34) provided for storage of the tasks in the interface is a shift register according to one of the preceding claims, wherein the control inputs of the shift register (29) are connected to the processors (22.1, 22.2, 22.3) for changing the sequence of the stored tasks.

8. A microprocessor arrangement according to claim 7 **characterised in that** the interface for allocation of the address bus to one of the peripheral units has an address bus distributor (35).

9. A microprocessor arrangement according to claim 7 or claim 8 **characterised in that** the interface (32) for actuation of the data bus distributor (40) and/or the address bus distributor (35) has a control circuit (33) which is connected on the input side to the address bus.

**Revendications**

1. Registre à décalage (1) muni

d'une entrée de données (D) en vue de la réception consécutive de plusieurs bits de données,

de plusieurs éléments de mémoire (4, 5, 6) binaires reliés à l'entrée de données (D) en vue de l'enregistrement respectivement d'un bit de données reçu,

d'une sortie de données (Q) pour la sortie des uniques bits de données mémorisés ainsi que

d'une première entrée de commande (SI) en vue de la réception d'un premier signal de commande binaire et

d'une logique de commande (7) reliée côté entrée à la première entrée de commande (SI) et côté sortie aux éléments de mémoire (4, 5, 6), qui contrôle les éléments de mémoire (4, 5, 6) par une valeur prédéterminée du premier signal de commande en vue de la réception d'un nouveau bit de données par l'intermédiaire de l'entrée de données (D) et/ou en vue de la délivrance d'un bit de données mémorisé par l'intermédiaire de la sortie de données (Q), et

d'une logique de commande (10) reliée côté entrée à la première entrée de commande (SI) et côté sortie aux éléments de mémoire (8, 9), qui augmente de 1 la valeur d'état de remplissage mémorisée dans les éléments de mémoire (8, 9) par une valeur prédéterminée du premier signal de commande,

**caractérisé par**

une seconde entrée de commande (SW) en vue de la réception d'un second signal de commande binaire, où la logique de commande (7) est reliée côté entrée aux sorties (Q, q_f1, q_f2) des éléments de mémoire (4, 5, 6) et à la seconde entrée de commande (SW) et contrôle les éléments de mémoire (4, 5, 6) par une valeur prédéterminée du second signal de commande lors d'un état de remplissage d'au moins deux en vue de la permutation des deux bits de données mémorisés côté sortie.

2. Registre à décalage (1) selon la revendication 1, **caractérisé en ce que**, en vue de la réception d'un troisième signal de commande binaire, est prévue une troisième entrée de commande (SO), où la logique de commande (7) est reliée côté entrée à la troisième entrée de commande (SO) et contrôle les éléments de mémoire (4, 5, 6) par une valeur prédéterminée du troisième signal de commande en vue de la délivrance d'un bit de données mémorisé par l'intermédiaire de la sortie de données (Q) et la logique de commande (10) est reliée côté entrée avec le troisième signal de commande (SO), qui diminue de 1 la valeur d'état de remplissage mémorisée dans les éléments de mémoire (8, 9) par une valeur prédéterminée du troisième signal de commande.

3. Registre à décalage (1) selon la revendication 2, **caractérisé en ce que** le nombre des éléments de mémoire binaires (8, 9) en vue de la mémorisation d'un nombre reproduisant l'état de remplissage est indépendant du nombre des bits de données à mémoriser et des éléments de mémoire binaires (4, 5, 6) s'y rapportant.

4. Registre à décalage (1) selon l'une des revendications précédentes, **caractérisé par** une quatrième entrée de commande (FB) en vue de la réception d'un quatrième signal de commande binaire, où la logique de commande (7) en vue de la réception du quatrième signal de commande est reliée côté entrée à la quatrième entrée de commande (FB) et contrôle les éléments de mémoire (4, 5, 6) par une valeur prédéterminée du quatrième signal de commande en vue de la permutation du bit de données reçu en premier avec celui reçu en dernier.

5. Registre à décalage (1) selon la revendication 4, **caractérisé par** une cinquième entrée de commande (INV) en vue de la réception d'un cinquième signal de commande binaire, où la logique de commande (7) en vue de la réception du cinquième signal de commande est reliée côté entrée à la cinquième entrée de commande (INV) et contrôle les éléments de mémoire (4, 5, 6) par une valeur prédéterminée du cinquième signal de commande après la permutation du bit de données reçu en premier avec celui reçu en dernier en vue de l'inversion du bit de données côté entrée.

6. Registre à décalage (1) selon l'une des revendications précédentes, **caractérisé en ce que** les éléments de mémoire sont des bascules (4, 5, 6, 8, 9).

7. Dispositif à microprocesseurs comprenant

plusieurs processeurs (22.1, 22.2, 22.3) et plusieurs unités périphériques (23.1, 23.2, 23.3),

un bus d'adresses en vue de transmission de commande depuis les processeurs aux unités périphériques,

un bus de données en vue de la transmission de données des processeurs aux unités périphériques, où les unités périphériques (23.1, 23.2, 23.3) en vue de la mémorisation temporaire des commandes transmises pendant la prise en charge de commandes précédentes présentent respectivement un registre à décalage (27.1, 27.2, 27.3),

une interface (24) reliée d'une part aux unités périphériques (23.1, 23.2, 23.3) et d'autre part aux processeurs (22.1, 22.2, 22.3) en vue d'une liaison des processeurs (22.1, 22.2, 22.3) avec les unités périphériques (23.1, 23.2, 23.3) pour un transfert de données,

où l'interface (24) présente un répartiteur de bus de données (28, 40) en vue de la répartition du bus de données (26) à l'une respective des unités périphériques (23.1, 23.2, 23.3) et un registre à décalage (29, 34) relié au bus d'adresse est prévu en vue de la mémorisation des commandes données/provenant des processeurs (22.1, 22.2, 22.3) et en vue de la sélection du répartiteur de bus de données (28) conformément aux commandes mémorisées,

**caractérisé en ce que**

le registre à décalage (29, 34) prévu en vue de la mémorisation des commandes dans l'interface est un registre à décalage selon l'une des revendications précédentes, où les entrées de commande du registre à décalage (29) sont reliées aux processeurs (22.1, 22.2, 22.3) en vue d'une modification dans la suite des commandes mémorisées.

**8.** Dispositif à microprocesseurs selon la revendication 7, **caractérisé en ce que** l'interface présente un répartiteur de bus d'adresse (35) en vue de la répartition du bus d'adresse à l'une des unités périphériques.

**9.** Dispositif à microprocesseurs selon la revendication 7 ou 8, **caractérisé en ce que** l'interface (32), en vue du choix du répartiteur de bus de données (40) et/ou du répartiteur de bus d'adresse (35) présente un commutateur de commande (33), qui est relié côté entrée au bus d'adresse.

Fig. 1

CLK
SI
SO
FB
INV
SW
D
Q

**Fig. 2**

Fig.3

11.1 — D
11.2 — SI
11.3 — SO
11.4 — FB
11.5 — INV
11.6 — SW
11.7 — Q
11.8 — q_f1
11.9 — q_f2
11.10 — q_t0
11.11 — q_t1

12

13

14.1 — d_f0
14.2
14.3 — d_f1
d_f2

EP 0 942 434 B1

Fig.4

EP 0 942 434 B1

Fig. 5

Fig. 6

Fig. 7

Fig. 8

Fig. 9

EP 0 942 434 B1